# EUROPEAN PATENT SPECIFICATION

(11) **EP 3 267 255 B1**
(45) Date of publication and mention of the grant of the patent: **12.07.2023**
(21) Application number: 16761568.1
(22) Date of filing: 01.03.2016
(51) Int. Cl.: B41C 1/10, B41M 1/08, B41N 1/00

(54) **LITHOGRAPHIC PRINTING ORIGINAL PLATE, METHOD FOR PRODUCING LITHOGRAPHIC PRINTING PLATE USING SAME, AND METHOD FOR PRODUCING PRINTED MATTER**
LITHOGRAFISCHE ORIGINALDRUCKPLATTE, VERFAHREN ZUR HERSTELLUNG EINER LITHOGRAFISCHEN ORIGINALDRUCKPLATTE DAMIT UND VERFAHREN ZUR HERSTELLUNG VON DRUCKSACHEN
PLANCHE ORIGINALE D'IMPRESSION LITHOGRAPHIQUE, PROCÉDÉ DE PRODUCTION DE PLANCHE D'IMPRESSION LITHOGRAPHIQUE L'UTILISANT, ET PROCÉDÉ DE PRODUCTION D'IMPRIMÉS

(30) Priority: 06.03.2015 JP 2015044430
(43) Date of publication of application: 10.01.2018
(73) Proprietor: Toray Industries, Inc., Tokyo 103-8666 (JP)
(72) Inventor: KASE, Yuki, Otsu-shi, Shiga 520-8558 (JP); IIHARA, Akihiro, Otsu-shi, Shiga 520-8558 (JP); MURASE, Seiichiro, Otsu-shi, Shiga 520-8558 (JP)
(74) Representative: Kador & Partner Part mbB
(86) International application number: PCT/JP2016/056194
(87) International publication number: WO 2016/143598

(56) References cited:
- EP-A1- 3 219 504
- EP-A1- 3 222 435
- WO-A1-2012/043282
- WO-A1-2012/099003
- JP-A- H10 130 559
- JP-A- 2001 232 959
- JP-A- 2005 015 755
- JP-A- 2005 309 126

## Description

### TECHNICAL FIELD

The present invention relates to a planographic printing plate original, a method of producing a planographic printing plate using the same, and a method of producing a printed matter. More specifically, the present invention relates to a planographic printing plate original including a heat sensitive layer having an excellent minute halftone dot reproducibility, a method of producing a planographic printing plate using the same, and a method of producing a printed matter.

### BACKGROUND ART

Various types of printing plates have been proposed so far, in which a silicone rubber or a fluorine resin is used for forming an ink repellent layer, and which are used for carrying out planographic printing without using dampening water (hereinafter, referred to as waterless planographic printing). The waterless planographic printing is a planographic printing method which uses a planographic printing plate in which an image area having ink acceptability and a non-image area having ink repellency are provided substantially on the same plane, wherein the difference in ink adhesion between these areas is utilized to allow an ink to adhere only to the image area, followed by transferring the adhered ink to an object to be printed, such as a paper, to achieve printing, and wherein the printing can be performed without using dampening water.

Various types of exposure methods have been proposed, for exposing a waterless planographic printing plate original. These methods are largely categorized into: methods in which UV light irradiation is carried out through an original film; and computer-to-plate (hereinafter, referred to as CTP) methods in which computer-generated digital data is directly written into a planographic printing plate original, without using an original film. Examples of the CTP method include: a method of irradiating a laser beam; a method of writing an image by a thermal head; a method of partially applying a voltage using pin electrodes; and a method of forming an ink repellent layer or an ink accepting layer by an ink-jet method. Among these, the method of irradiating a laser beam is better than other methods, in terms of resolution and plate making speed.

The method of irradiating a laser beam is categorized into two systems: a photon mode system which utilizes a photoreaction; and a heat mode system in which photothermal conversion is used to allow a thermal reaction to occur. In particular, the usefulness of the heat mode system is increasing, due to the advantage that it can be performed in a light room, and rapid progress in semiconductor lasers which serve as light sources. A waterless planographic printing plate utilizes the heat mode system, in which image formation is carried out by a layer (hereinafter, referred to as heat sensitive layer) in which photothermal conversion takes place to allow a thermal reaction to occur, when the laser beam is irradiated thereto. The heat sensitive layer contains an infrared absorbing dye, and a thermally reactive polymer in which a reaction occurs due to heat, as essential components. However, if a heat sensitive layer composition contains only an infrared absorbing dye and a thermally reactive polymer, cissing occurs during the coating of a solution containing the heat sensitive layer composition, and it is unable to obtain a printing durability.

### PRIOR ART DOCUMENTS

### PATENT DOCUMENTS

For example, Patent Document 1 proposes the incorporation of a polyurethane in an ink accepting layer, in order to improve coating properties (to reduce the occurrence of cissing) during the coating of a solution containing a heat sensitive layer composition, and to improve the printing durability.

Patent Document 2 provides a direct drawing-waterless lithographic printing original plate which has at least a heat sensitive layer and a silicone rubber layer on a substrate in this order, wherein the heat sensitive layer contains non-photosensitive particles and the average particle diameter of the non-photosensitive particles is not less than ½ of the average film thickness of a portion of the heat sensitive layer where the non-photosensitive particles are not present.

Patent Document 3 provides an original plate for a direct drawing-type waterless lithographic printing plate having at least a heat sensitive layer and a silicone rubber layer on a substrate in this order, wherein the heat sensitive layer in the original plate for a direct drawing-type waterless printing plate contains at least a novolac resin, a polyurethane and a photothermal-converting substance and has a phase separation structure having at least a phase that contains the novolac resin and a phase that contains the polyurethane.

Patent Document 4, a document according to Art. 54(3) EPC, discloses a water-based lithographic printing method and a method of producing a printed material including the steps of allowing a water-based ink to adhere to a surface of a heat sensitive layer of a lithographic printing plate having a surface on which a heat-repellent layer and a heat sensitive layer exist and transferring the adhering water-based ink directly or via a blanket to a printing substrate.

Patent Document 5, a document according to Art. 54(3) EPC, discloses a waterless lithographic printing plate precursor having at least a heat sensitive layer and an ink-repellent layer provided on a substrate, wherein the ink-repellent layer contains an ink repelling liquid, the ink repellent liquid having a boiling point of not less than 150°C at 1 atmospheric pressure.
Patent Document 1: JP 2000-330268 A (CLAIMS)
Patent Document 2: WO 2012/043282 A1
Patent Document 3: WO 2012/099003 A1
Patent Document 4: EP 3 222 435 A1
Patent Document 5: EP 3 219 504 A1

### SUMMARY OF THE INVENTION

### PROBLEMS TO BE SOLVED BY THE INVENTION

In a directly imageable waterless planographic printing plate original, such as one described in Patent Document 1, there is a relationship that, although an increase in the content of the polyurethane leads to an improvement in the coating properties (reduction in cissing) during the coating of a solution containing a heat sensitive layer composition, and an improvement in the printing durability, it results in a decrease in the minute halftone dot reproducibility, at the same time.

Further, scumming is more likely to occur, when printing is performed by a method which includes a step of irradiating an active energy ray to an object to be printed, after transferring the ink to the object to be printed. As a result, it becomes difficult to obtain a decent printed matter.

Accordingly, an object of the present invention is to provide a planographic printing plate original: in which the occurrence of cissing during the coating can be prevented; which has a favorable printing durability and halftone dot reproducibility; and in which the occurrence of scumming can be prevented.

### MEANS FOR SOLVING THE PROBLEMS

In order to solve the above mentioned problems, the planographic printing plate original according to the present invention is defined according to claim 1.

Preferred embodiments of the planographic printing plate original are defined in claims 2 to 5.

Further, in order to solve the above mentioned problems, the method of producing a planographic printing plate, according to the present invention is defined in claim 6.

Still further, in order to solve the above mentioned problems, the method of producing a printed matter, according to the present invention is defined in claim 7.

Preferred embodiments of the method of producing a printed matter are defined in claims 8 and 9. EFFECT OF THE INVENTION

According to the present invention, it is possible to obtain a planographic printing plate original: in which the occurrence of cissing during the coating of a solution containing a heat sensitive layer composition can be prevented; which has a favorable printing durability and minute halftone dot reproducibility; and in which the occurrence of scumming can be prevented.

### MODE FOR CARRYING OUT THE INVENTION

The planographic printing plate original according to the present invention includes a substrate; and at least a silicone rubber layer and a heat sensitive layer provided on the substrate. The above described planographic printing plate original is characterized in that the heat sensitive layer contains at least a polyurethane having a carbonate structure and contains, in the main chain thereof, an alkyl chain having 6 or more carbon atoms. The planographic printing plate original according to the present invention is used as a waterless planographic printing plate original. The waterless planographic printing plate original as used herein refers to a planographic printing plate original which allows for printing without the use of dampening water. Further, a directly imageable waterless planographic printing plate original as used herein refers to a waterless planographic printing plate original onto which computer-generated digital data can be directly written, using a laser beam.

The planographic printing plate original according to the present invention will be described below.

As the substrate, it is possible to use a known paper, metal, glass, or film, which is dimensionally stable and which has been conventionally used as a substrate of a printing plate. Specific examples thereof include: papers; papers laminated with a plastic (such as polyethylene, polypropylene, or polystyrene), plates of metals such as aluminum (including aluminum alloys), zinc, and copper; glass plates made of soda lime, and quartz; silicon wafer; films of plastics such as cellulose acetate, polyethylene terephthalate, polyethylene, polyester, polyamide, polyimide, polystyrene, polypropylene, polycarbonate, and polyvinyl acetal; and papers and plastic films on which any of the above described metals is laminated or vapor-deposited. The plastic film may be a transparent film or a non-transparent film. A non-transparent film is preferred in terms of plate inspectability.

Among these substrates, an aluminum plate is particularly preferred, because it is not only dimensionally stable, but also inexpensive. Further, a polyethylene terephthalate film is particularly preferred, as a flexible substrate for light printing.

The thickness of the substrate is not particularly limited, and a thickness compatible with a printing machine used in the planographic printing may be selected.

Next, the heat sensitive layer which is used in the present invention will be described. The heat sensitive layer is preferably a layer whose physical properties change by laser drawing and/or a layer whose adhesive strength to the silicone rubber layer is reduced du to laser drawing. A preferred example of the heat sensitive layer is a layer obtained by: preparing a solution containing each of the following components: (1) a novolac resin, (2) an organic complex compound, (3) a photothermal conversion material and (4) a polyurethane; and then heating and drying the solution as required.

The planographic printing plate original according to the present invention is characterized in that the heat sensitive layer contains a polyurethane having a carbonate structure and contains, in the main chain thereof, an alkyl chain having 6 or more carbon atoms.

In a directly imageable waterless planographic printing plate original, such as one described in Patent Document 1, although the incorporation of a polyurethane as a binder polymer serves to provide the effects of reducing the cissing during the coating of a solution containing a heat sensitive layer composition and of improving the printing durability, it leads to a decrease in the minute halftone dot reproducibility, at the same time.

Since the heat sensitive layer in the planographic printing plate original according to the present invention contains a polyurethane having a carbonate structure and contains, in the main chain thereof, an alkyl chain having 6 or more carbon atoms, it is possible to obtain a planographic printing plate original which is excellent in minute halftone dot reproducibility of the heat sensitive layer and printing durability.

Respective components constituting the heat sensitive layer will now be described.

### (1) Novolac Resin

Examples of the novolac resin preferably used in the heat sensitive layer, in the planographic printing plate original according to the present invention, include novolac resins obtained by allowing a phenol, such as those exemplified below, to react with an aldehyde, such as those exemplified below, in the presence of an acidic catalyst.

Examples of the phenols include: phenol; cresols such as m-cresol, p-cresol, and o-cresol; xylenols such as 2,3-xylenol, 2,5-xylenol, 3,5-xylenol, and 3,4-xylenol; alkyl phenols; alkoxy phenols; isopropenyl phenols; allyl phenols; and polyhydroxy phenols. These may be used singly, or in combination of two or more kinds. Among these phenols, phenol or o-cresol is preferred.

Examples of the aldehydes include formaldehyde, paraformaldehyde, trioxane, acetaldehyde, and propionaldehyde. These may be used singly, or in combination of two or more kinds. Among these aldehydes, formaldehyde is preferred.

As the acidic catalyst, hydrochloric acid, sulfuric acid, formic acid, oxalic acid, or paratoluenesulfonic acid, can be used.

Among the above described novolac resins, a phenol novolac resin or an o-cresol novolac resin is preferred.

The novolac resin preferably has a weight average molecular weight of 5,000 or less, and more preferably 4,000 or less. The use of a novolac resin having a weight average molecular weight of 5,000 or less facilitates the breakage of crosslinking points during the laser irradiation, and allows for further improving the sensitivity of the heat sensitive layer. At the same time, the novolac resin preferably has a weight average molecular weight of 500 or more, and more preferably, 800 or more. The use of a novolac resin having a weight average molecular weight of 500 or more serves to improve the adhesion between the heat sensitive layer and the silicone rubber layer. In the present invention, the weight average molecular weight of the novolac resin refers to a value measured by a GPC (gel permeation chromatography) method. Note, however, that the GPC method allows for measuring a relative molecular weight distribution and weight average molecular weight, and that the weight average molecular weight as used in the present invention is a molecular weight converted in terms of polystyrene, which is a standard material.

The content of the novolac resin is preferably from 20 to 95% by mass with respect to the total solid content of the heat sensitive layer, in terms of the coating properties. The lower limit of the content of the novolac resin is more preferably 50% by mass or more, and the upper limit thereof is more preferably 90% by mass or less.

### (2) Organic Complex Compound

In the planographic printing plate original according to the present invention, the organic complex compound preferably used in the heat sensitive layer is composed of a metal and an organic compound, and functions as a crosslinking agent for a polymer containing active hydrogen and/or as a catalyst in a thermosetting reaction. Even in cases where the organic complex compound functions as a crosslinking agent, the heat sensitive layer may further contain another crosslinking agent.

Examples of the organic complex compound preferably used in the heat sensitive layer in the present invention include: organic complex salts in which an organic ligand is coordinated to a metal; organic-inorganic complex salts in which an organic ligand and an inorganic ligand are coordinated to a metal; and metal alkoxides in which a metal and an organic molecule are covalently bound via an oxygen atom. Among these, a metal chelate compound in which a ligand has two or more donor atoms and forms a ring containing a metal atom is preferably used, in terms of the stability of the organic complex compound itself, and the stability of the solution of the heat sensitive layer composition.

Preferred major metals forming the organic complex compound include Al (III), Ti (IV), Mn (II), Mn (III), Fe (II), Fe (III), Co (II), Co (III), Ni (II), Ni (IV), Cu (I), Cu (II), Zn (II), Ge, In, Sn (II), Sn (IV), Zr (IV), and Hf (IV). Al (III) is particularly preferred, because the effect of improving the sensitivity is easily obtained, and Ti (IV) is particularly preferred, because the resistance to a printing ink or an ink washing agent is more easily obtained.

Further, the ligand may be, for example, a compound which contains a coordinating group containing an oxygen atom, a nitrogen atom, or sulfur atom as a donor atom. Specific examples of the coordinating group containing an oxygen atom as a donor atom include: -OH (alcohol, enol and phenol), -COOH (carboxylic acid), >C=O (aldehyde, ketone, quinone), -O- (ether), -COOR (ester, wherein R represents an aliphatic or an aromatic hydrocarbon), -N=O (nitroso compound), -NO₂ (nitro compound), >N-O (N-oxide), -SO₃H (sulfonic acid), and -PO₃H₂ (phosphorous acid). Specific examples of the coordinating group containing a nitrogen atom as a donor atom include: -NH₂ (primary amine, amide, hydrazine), >NH (secondary amine, hydrazine), >N- (tertiary amine), -N=N- (azo compound, heterocyclic compound), =N-OH (oxime), -NO₂ (nitro compound), -N=O (nitroso compound), >C=N- (Schiff base, heterocyclic compound), >C=NH (aldehyde, ketone imine, enamines), and -NCS (isothiocyanate). Specific examples of the coordinating group containing a sulfur atom as a donor atom include: -SH (thiol), -S- (thioether), >C=S (thioketone, thioamide), =S- (heterocyclic compound), -C(=O)-SH, -C(=S)-OH, -C(=S)-SH (thiocarboxylic acid), and -SCN (thiocyanate).

Among the organic complex compounds formed from the above mentioned metals and ligands, preferably used compounds include complex compounds of metals such as Al (III), Ti (IV), Fe (II), Fe (III), Mn (III), Co (II), Co (III), Ni (II), Ni (IV), Cu (I), Cu (II), Zn (II), Ge, In, Sn (II), Sn (IV), Zr (IV) and Hf (IV), with β-diketones, amines, alcohols and carboxylic acids. Further, a particularly preferred organic complex compound may be, for example, an acetylacetone complex or an acetoacetic acid ester complex of Al (III), Fe (II), Fe (III), Ti (IV), or Zr (IV).

Specific examples of such an organic complex compound include the following compounds:
aluminum tris(acetylacetonate), aluminum tris(ethylacetoacetate), aluminum tris(propylacetoacetate), aluminum tris(butylacetoacetate), aluminum tris(hexylacetoacetate), aluminum tris(nonylacetoacetate), aluminum tris(hexafluoropentadionate), aluminum tris(2,2,6,6-tetramethyl-3,5-heptanedionate), aluminum bis(ethylacetoacetate)-mono(acetylacetonate), aluminum bis(acetylacetonate)-mono(ethylacetoacetate), aluminum bis(propylacetoacetate)-mono(acetylacetonate), aluminum bis(butylacetoacetate)-mono(acetylacetonate), aluminum bis(hexylacetoacetate)-mono(acetylacetonate), aluminum bis(propylacetoacetate)-mono(ethylacetoacetate), aluminum bis(butylacetoacetate)-mono(ethylacetoacetate), aluminum bis(hexylacetoacetate)-mono(ethylacetoacetate), aluminum bis(nonylacetoacetate)-mono(ethylacetoacetate), aluminum dibutoxide-mono(acetylacetonate), aluminum diisopropoxide-mono(acetylacetonate), aluminum diisopropoxide-mono(ethylacetoacetate), aluminum-s-butoxide-bis(ethylacetoacetate), aluminum di-s-butoxide-mono(ethylacetoacetate), aluminum diisopropoxide-mono(-9-octadecenylacetoacetate), titanium triisopropoxide-mono(allylacetoacetate), titanium diisopropoxide-bis(triethanolamine), titanium di-n-butoxide-bis(triethanolamine), titanium diisopropoxide-bis(acetylacetonate), titanium di-n-butoxide-bis(acetylacetonate), titanium diisopropoxide-bis(2,2,6,6-tetramethyl-3,5-heptanedionate), titanium diisopropoxide-bis(ethylacetoacetate), titanium di-n-butoxide-bis(ethylacetoacetate), titanium tri-n-butoxide-mono(ethylacetoacetate), titanium triisopropoxide-mono(methacryloxyethylacetoacetate), titanium oxide-bis(acetylacetonate), titanium tetra(2-ethyl-3-hydroxyhexyloxide), titanium dihydroxy-bis(lactate), titanium (ethyleneglycolate)-bis(dioctylphosphate); zirconium di-n-butoxide-bis(acetylacetonate), zirconium tetrakis(hexafluoropentanedionate), zirconium tetrakis(trifluoropentanedionate), zirconium tri-n-propoxide-mono(methacryloxyethylacetoacetate), zirconium tetrakis(acetylacetonate), zirconium tetrakis(2,2,6,6-tetramethyl-3,5-heptanedionate), triglycolate zirconic acid, trilactate zirconic acid, iron (III) acetylacetonate, dibenzoylmethane iron (II), tropolone iron, tristropolono-iron (III), hinokitiol iron, trishinokitiolo-iron (III), acetoacetic acid ester iron (III), iron (III) benzoylacetonate, iron (III) diphenylpropanedionate, iron (III) tetramethylheptanedionate, and iron (III) trifluoropentanedionate. Two or more of these compounds may be contained.

The content of the organic complex compound is preferably from 0.5 to 50% by mass, and more preferably from 3 to 30% by mass, with respect to the total solid content of the heat sensitive layer. When the content of the organic complex compound is 0.5% by mass or more, it is possible to obtain the effect of functioning as a crosslinking agent for a polymer containing active hydrogen, and/or the effect of functioning as a catalyst in a thermosetting reaction, the effect of improving the sensitivity, and the effect of further enhancing the resistance to a printing ink or an ink washing agent, as described above. At the same time, when the content of the organic complex compound is 50% by mass or less, a high printing durability of the printing plate can be maintained.

### (3) Photothermal Conversion Material

In the planographic printing plate original according to the present invention, the photothermal conversion material preferably used in the heat sensitive layer is not particularly limited as long as it absorbs a laser beam, and a pigment or a dye capable of absorbing infrared radiation or near-infrared radiation is preferred. Examples thereof include: black pigments such as carbon black, carbon graphite, aniline black, and cyanine black; green pigments such as phthalocyanine-based and naphthalocyanine-based pigments; crystal water-containing inorganic compounds; powders of metals such as iron, copper, chromium, bismuth, magnesium, aluminum, titanium, zirconium, cobalt, vanadium, manganese, and tungsten; and sulfides, hydroxides, silicates, sulfates, phosphates, diamine compound complexes, dithiol compound complexes, phenol thiol compound complexes, and mercaptophenol compound complexes of these metals.

Further, examples of preferably used dyes capable of absorbing infrared radiation or near-infrared radiation include the following dyes which are for use in electronics and recording and which have a maximum absorption wavelength of from 700 nm to 1,500 nm: cyanine dyes, azulenium dyes, squarylium dyes, croconium dyes, azo disperse dyes, bisazostilbene dyes, naphthoquinone dyes, anthraquinone dyes, perylene dyes, phthalocyanine dyes, naphthalocyanine metal complex dyes, polymethine dyes, dithiol nickel complex dyes, indoaniline metal complex dyes, intermolecular CT dyes, benzothiopyran-based spiropyran, and nigrosine dyes.

Among these dyes, one having a high molar extinction coefficient ε is preferably used. Specifically, the value of ε is preferably 1 × 10⁴ or more, and more preferably 1 × 10⁵ or more. The use of a dye having a value of ε of 1 × 10⁴ or more allows for further enhancing the initial sensitivity.

Two or more of these photothermal conversion materials may be contained. The incorporation of two or more types of photothermal conversion materials having different absorption wavelengths allows the resulting heat sensitive layer to be compatible with two or more types of laser beams having different wavelengths.

Among these, carbon black and a dye capable of absorbing infrared radiation or near-infrared radiation are preferred, in terms of photothermal conversion rate, economic efficiency, and handleability.

The content of the photothermal conversion material(s) as described above is preferably from 0.1 to 70% by mass, and more preferably from 0.5 to 40% by mass, with respect to the total solid content of the heat sensitive layer. When the content of the photothermal conversion material is 0.1% by mass or more, the sensitivity to a laser beam can further be enhanced. At the same time, when the content is 70% by mass or less, a high printing durability of the printing plate can be maintained.

### (4) Polyurethane

In the planographic printing plate original according to the present invention, the polyurethane to be included in the heat sensitive layer may be, for example, a polyurethane obtained by reacting a polyisocyanate and a polyol, which are exemplified below. The polyurethane may be in the form of a straight or branched chain, and may contain any of various types of functional groups, such as hydroxyl group. Two or more of these may be contained. As the polyisocyanate, an aromatic polyisocyanate, an alicyclic polyisocyanate, or an aliphatic polyisocyanate can be used.

Examples of the aromatic polyisocyanate include paraphenylene diisocyanate, 2,4- or 2,6-toluylene diisocyanate (TDI), 4,4'-diphenylmethane diisocyanate (MDI), tolidine diisocyanate (TODI), and xylylene diisocyanate (XDI). These compounds may be used singly, or as a mixture of two or more kinds thereof.

Examples of the alicyclic polyisocyanate and aliphatic polyisocyanate include hexamethylene diisocyanate, isophorone diisocyanate, norbornane diisocyanate, hydrogenated diphenylmethane diisocyanate, and hydrogenated m-xylene diisocyanate. These compounds may be used singly, or as a mixture of two or more kinds thereof.

Further, modified products, and derivatives of the polyisocyanate can be used in the present invention. Such a modified product or a derivative may be, for example: a urethane-modified product which is reaction product of a polyisocyanate with an alcohol; a dimer (also referred to as uretidione) or trimer (also referred to as isocyanurate) as a reaction product of two or three polyisocyanates; a polycarbodiimide produced by decarbonation; an allophanate-modified product, a burette-modified product, or a urea-modified product which is a reaction product of a polyisocyanate with an alcohol, or an amine compound; or a blocked isocyanate.

The polyol is preferably a polycarbonate polyol, since it has a high thermal decomposability. Examples thereof include: a ring-opening polymerization product of ethylene carbonate, obtained by using as an initiator, a low molecular weight polyol such as ethylene glycol, propylene glycol, 1,3-propanediol, 1,4-butanediol, 1,3-butylene glycol, 1,5-pentanediol, or 1,6-hexanediol; and an amorphous polycarbonate polyol obtained by copolymerizing the ring-opening polymerization product of ethylene carbonate with a divalent alcohol such as 1,4-butanediol, 1,5-pentanediol, 3-methyl-1,5-pentanediol, or 1,6-hexanediol.

In the planographic printing plate original according to the present invention, the polyurethane included in the heat sensitive layer is characterized by having a carbonate structure. It has been found out so far that the heat sensitive layer is decomposed due to heat generated by a photothermal conversion layer, when subjected to laser irradiation. However, no thought has hitherto been given to the decomposition of the polyurethane included in the heat sensitive layer. When the polyurethane having a carbonate structure is included in the heat sensitive layer, the thermal decomposition of the heat sensitive layer is facilitated, and thus an excellent minute halftone dot reproducibility can be obtained.

In the planographic printing plate original according to the present invention, the thermal decomposability of the heat sensitive layer containing the polyurethane can be easily measured by Macro Thermogravimetric Analyzer TGA-50 (hereinafter referred to as TGA) (manufactured by SHIMADZU CORPORATION). The measurement was carried out by increasing the temperature in the TGA according to the following procedure, and by measuring the temperature at which the weight reduction ratio (100 - (weight at a predetermined temperature / initial weight) * 100) reaches 30% or more (hereinafter referred to as thermal decomposition temperature).

The temperature in the TGA was increased at a heating temperature of 20°C/min, and maintained at 100°C for 20 min, and then increased at a heating temperature of 20°C/min and maintained at 200°C for 20 min. Further, the temperature was increased at a heating temperature of 10°C/min and maintained at 590°C for 1 min (measurement conditions: under pressure, 20°C, 20 ml (mL/min)). A heat sensitive layer having a lower thermal decomposition temperature, when the temperature in the TGA is increased, has a better decomposability and better minute halftone dot reproducibility. The thermal decomposition temperature is preferably 320°C or lower, more preferably 310°C or lower, and still more preferably 300°C or lower. Further, the temperature at which the weight reduction ratio reaches 30% or more is preferably 270°C or higher, since it otherwise causes an insufficient solvent resistance. The temperature is more preferably 280°C or higher.

Further, in the planographic printing plate original according to the present invention, a polyurethane contains an alkyl chain having 6 or more carbon atoms, as the polyurethane having a carbonate structure to be contained in the heat sensitive layer, because a localized cohesion can be further obtained, thereby facilitating the thermal decomposition of the heat sensitive layer.

The content of the polyurethane having a carbonate structure in the heat sensitive layer is preferably 10% by mass or more, and more preferably 20% by mass or more, with respect to the total solid content of the heat sensitive layer, because it allows for reducing the occurrence of cissing during the coating of the solution containing the heat sensitive layer composition, and obtaining the printing durability. At the same time, the content of the polyurethane is preferably 50% by mass or less, and more preferably 40% by mass or less, with respect to the total solid content of the heat sensitive layer, in terms of maintaining the excellent minute halftone dot reproducibility.

Further, in the planographic printing plate original according to the present invention, the heat sensitive layer may contain any of various types of additives, as necessary. For example, the heat sensitive layer may contain a silicone-based surfactant, or a fluorine-based surfactant, in order to improve the coating properties. In addition, the heat sensitive layer may contain a silane coupling agent, or a titanium coupling agent, in order to enhance the adhesion with the silicone rubber layer. The content of these additives varies depending on the purposes for which they are used. However, the content is usually from 0.1 to 30% by mass, with respect to the total solid content of the heat sensitive layer.

The heat sensitive layer preferably has a film thickness of from 0.1 to 10 g/m², in terms of the printing durability and productivity. The lower limit of the film thickness is more preferably 0.5 g/m² or less, and the upper limit is more preferably 7 g/m² or less.

In cases where the heat sensitive layer is subjected to heat drying, the heat sensitive layer is preferably dried at a heat drying temperature of 30°C or higher and 190°C or lower, in terms of the minute halftone dot reproducibility and the solvent resistance. The lower limit of the heat drying temperature is more preferably 50°C or higher, and the upper limit is more preferably 150°C or lower.

The planographic printing plate original according to the present invention may include a primer layer between the substrate and the heat sensitive layer, for the purpose of improving the adhesion between the substrate and the heat sensitive layer, preventing halation, improving the plate inspectability, improving the heat insulation, and improving the printing durability. Examples of the primer layer include those disclosed in JP 2004-199016 A.

In the planographic printing plate original according to the present invention, the silicone rubber layer may be, for example, a layer obtained by coating an addition reaction type silicone rubber layer composition or a condensation reaction type silicone rubber layer composition, or a layer obtained by coating a solution of any of these compositions, followed by heating and drying, as necessary.

The addition reaction type silicone rubber layer composition preferably contains at least a vinyl group-containing organopolysiloxane, a SiH group-containing compound (addition reaction type crosslinking agent) and a curing catalyst. Further, the addition reaction type silicone rubber layer composition may contain a reaction inhibitor.

The vinyl group-containing organopolysiloxane has a structure represented by the following general formula (I), and has a vinyl group at an end of the main chain or in the main chain. In particular, one having a vinyl group at an end of the main chain is preferred. Two or more of these vinyl group-containing organopolysiloxanes may be contained.

-(SiR¹R²-O-)ₙ- (I)

In the general formula (I), n represents an integer of 2 or more; and R¹s and R²s may be the same as or different from each other, and each represents a saturated or unsaturated hydrocarbon group having from 1 to 50 carbon atoms. The hydrocarbon group may be in the form of a straight chain, a branched chain, or a ring, and may contain an aromatic ring.

In the above Formula, it is preferred that methyl groups account for 50% or more of all the groups represented by R¹ and R², in terms of the ink repellency of the printing plate. Further, the vinyl group-containing organopolysiloxane preferably has a weight average molecular weight of from 10,000 to 600,000, in terms of the handleability, and the ink repellency and scratch resistance of the printing plate.

The SiH group-containing compound may be, for example, an organohydrogenpolysiloxane, or an organic polymer containing a diorganohydrogensilyl group. Preferred is an organohydrogenpolysiloxane. Two or more of these SiH group-containing compounds may be contained.

The organohydrogenpolysiloxane has a molecular structure in the form of a straight chain, a ring, a branched chain, or a net, and may be, for example: a polymethylhydrogensiloxane with both terminals of the molecular chain blocked with trimethylsiloxy groups; a dimethylsiloxane · methylhydrogensiloxane copolymer with both terminals of the molecular chain blocked with trimethylsiloxy groups; a dimethylsiloxane · methylhydrogensiloxane · methylphenylsiloxane copolymer with both terminals of the molecular chain blocked with trimethylsiloxy groups; a dimethylpolysiloxane with both terminals of the molecular chain blocked with dimethylhydrogensiloxy groups; a dimethylsiloxane · methylphenylsiloxane copolymer with both terminals of the molecular chain blocked with dimethylhydrogensiloxy groups; a methylphenylpolysiloxane with both terminals of the molecular chain blocked with dimethylhydrogensiloxy groups; an organopolysiloxane copolymer composed of siloxane units represented by the formula R₃SiO_{1/2}, siloxane units represented by the formula R₂HSiO_{1/2}, and siloxane units represented by the formula SiO_{4/2}; an organopolysiloxane copolymer composed of siloxane units represented by the formula R₂HSiO_{1/2}, and siloxane units represented by the formula SiO_{4/2}; an organopolysiloxane copolymer composed of siloxane units represented by the formula RHSiO_{2/2}, and siloxane units represented by the formula RSiO_{3/2} or siloxane units represented by the formula HSiO_{3/2}. Two or more kinds of these organopolysiloxanes may be used. In the above mentioned formulae, each of Rs independently represents a monovalent hydrocarbon group other than an alkenyl group, and a hydrogen atom contained in the hydrocarbon group may be substituted with another group. Examples of the monovalent hydrocarbon group include: alkyl groups such as methyl group, ethyl group, propyl group, butyl group, pentyl group, hexyl group, and heptyl group; allyl groups such as phenyl group, tolyl group, xylyl group, and naphthyl group; aralkyl groups such as benzyl group, and phenethyl group; and halogenated alkyl groups such as chloromethyl group, 3-chloropropyl group, and 3,3,3-trifluoropropyl group.

The organic polymer containing a diorganohydrogensilyl group may be, for example, an oligomer obtained by copolymerizing a dimethylhydrogensilyl group-containing (meth)acrylic monomer such as dimethylhydrogensilyl (meth)acrylate or dimethylhydrogensilylpropyl (meth)acrylate, with a monomer such as methyl (meth)acrylate, ethyl (meth)acrylate, butyl (meth)acrylate, ethylhexyl (meth)acrylate, lauryl (meth)acrylate, styrene, α-methylstyrene, maleic acid, vinyl acetate, or allyl acetate.

The content of the SiH group-containing compound in the silicone rubber layer composition is preferably 0.5% by mass or more, and more preferably 1% by mass or more, in terms the curability of the silicone rubber layer. At the same time, the content is more preferably 20% by mass or less, and more preferably 15% by mass or less.

The use of a reaction inhibitor is also preferred, because it allows for adjusting the curing rate of the silicone rubber layer. Examples of preferred reaction inhibitors include nitrogen-containing compounds, phosphorus compounds, and unsaturated alcohols. An acetylene group-containing alcohol is preferably used. Two or more of these reaction inhibitors may be contained. The content of the reaction inhibitor in the silicone rubber layer composition is preferably 0.01% by mass or more, and more preferably 0.1% by mass or more, in terms of the stability of the silicone rubber layer composition or a solution thereof. Further, the content of the reaction inhibitor in the silicone rubber layer composition is preferably 20% by mass or less, and more preferably 15% by mass or less, in terms of the curability of the silicone rubber layer.

The use of a curing catalyst is also preferred, because it allows for accelerating the curing rate of the silicone rubber layer. A preferred curing catalyst is selected from known curing catalysts. The curing catalyst is preferably a platinum compound. Specific examples thereof include a simple substance of platinum, platinum chloride, chloroplatinic acid, an olefin coordinated platinum, an alcohol modified complex of platinum, and a methylvinylpolysiloxane complex of platinum. Two or more of these curing catalysts may be contained. The content of the curing catalyst in the silicone rubber layer composition is preferably 0.001% by mass or more, and more preferably 0.01% by mass or more, in terms of the curability of the silicone rubber layer. At the same time, the content of the curing catalyst in the silicone rubber layer composition is preferably 20% by mass or less, and more preferably 15% by mass or less, in terms of the stability of the silicone rubber layer composition or a solution thereof.

In addition to these components, the addition reaction type silicone rubber layer composition may also contain: a hydroxyl group-containing organopolysiloxane or a hydrolyzable functional group-containing silane (or siloxane); a known filler, such as silica, for the purpose of enhancing the rubber strength; and a known silane coupling agent for the purpose of improving the adhesion. Examples of preferred silane coupling agents include alkoxysilanes, acetoxysilanes, and ketoximino silanes. Particularly preferred is one including a vinyl group or an allyl group.

The condensation reaction type silicone rubber layer composition preferably contains at least a hydroxyl group-containing organopolysiloxane, a crosslinking agent, and a curing catalyst.

The hydroxyl group-containing organopolysiloxane has a structure represented by the general formula (I), and contains a hydroxyl group at an end of the main chain or in the main chain. In particular, one having a hydroxyl group at an end of the main chain is preferred. Two or more of these hydroxyl group-containing organopolysiloxanes may be contained.

Examples of the crosslinking agent include de-acetylated, de-oximated, de-alcoholated, de-acetonated, de-amidated and de-hydroxylaminated silicon compounds and other types of silicon compounds represented by the following general formula (II):

(R³)₄₋ₘSiXₘ (II)

wherein m represents an integer of from 2 to 4; R³s may be the same as or different from each other, and each represents a substituted or non-substituted alkyl group having one or more carbon atoms, an alkenyl group, an allyl group, or a group obtained by combining any of these groups; and Xs may be the same as or different from each other, and each represents a hydrolyzable group. Examples of the hydrolyzable group include acyloxy groups such as acetoxy group; ketoxime groups such as methylethylketoxime group; alkoxy groups such as methoxy group, ethoxy group, propoxy group, and butoxy group; alkenyloxy groups such as isopropenoxy group; acylalkylamino groups such as acetylethylamino group; and aminoxy groups such as dimethylaminoxy group. In the above Formula, m, which is the number of the hydrolyzable groups, is preferably 3 or 4.

Specific examples of the crosslinking agent include: acetoxysilanes such as methyltriacetoxysilane, ethyltriacetoxysilane, vinyltriacetoxysilane, allyltriacetoxysilane, phenyltriacetoxysilane, and tetraacetoxysilane; ketoximino silanes such as vinylmethylbis(methylethylketoximino)silane, methyltris(methylethylketoximino)silane, ethyltris(methylethylketoximino)silane, vinyltris(methylethylketoximino)silane, allyltris(methylethylketoximino)silane, phenyltris(methylethylketoximino)silane, and tetrakis(methylethylketoximino)silane; alkoxysilanes such as methyltrimethoxysilane, methyltriethoxysilane, ethyltrimethoxysilane, ethyltriethoxysilane, tetraethoxysilane, tetrapropoxysilane, vinyltrimethoxysilane, vinyltriethoxysilane, allyltriethoxysilane, and vinyltriisopropoxysilane; alkenyloxysilanes such as vinyltrisisopropenoxysilane, diisopropenoxydimethylsilane, and triisopropenoxymethylsilane; and tetraallyloxysilane; but not limited thereto. Among these, an acetoxysilane or a ketoximino silane is preferred, in terms of the curing rate of the silicone rubber layer, and the handleability. Two or more of these compounds may be contained.

The content of the crosslinking agent in the silicone rubber layer composition is preferably 0.5% by mass or more, and more preferably 1% by mass or more, in terms of the stability of the silicone rubber layer composition or a solution thereof. At the same time, the content of the crosslinking agent in the silicone rubber layer composition is preferably 20% by mass or less, and more preferably 15% by mass or less, in terms of the strength of the silicone rubber layer and the scratch resistance of the printing plate.

Examples of the curing catalyst include organic carboxylic acids, acids, alkalis, amines, metal alkoxides, metal diketonates, and organic acid salts of metals such as tin, lead, zinc, iron, cobalt, calcium and manganese. Specific examples thereof include dibutyltin diacetate, dibutyltin dioctate, dibutyltin dilaurate, zinc octylate, and iron octylate. Two or more of these curing catalysts may be contained.

The content of the curing catalyst in the silicone rubber layer composition is preferably 0.001% by mass or more, and more preferably 0.01% by mass or more, in terms of the curability and the adhesion of the silicone rubber layer. At the same time, the content of the curing catalyst in the silicone rubber layer composition is preferably 15% by mass or less, and more preferably 10% by mass or less, in terms of the stability of the silicone rubber layer composition or a solution thereof.

Further, the silicone rubber layer of the waterless planographic printing plate original according to the present invention preferably contains a silicone oil, for the purpose of improving the minute halftone dot reproducibility, and raising the scumming start temperature. The incorporation of the silicone oil accelerates the permeation of a pre-treatment liquid into the silicone layer, and thereby facilitates the dissolution of the surface of the heat sensitive layer, and improves the minute halftone dot reproducibility. Further, since the silicone oil exudes to the surface of the silicone rubber layer during the printing, and facilitates the peeling of the ink to improve the ink repellency, it is possible to raise the scumming start temperature. The silicone oil preferably has a boiling point at 1 atm of 150°C or higher. When the silicone oil has a boiling point of 150°C or higher, it is possible to reduce the volatilization of the silicone oil during the production of the waterless planographic printing plate original, and thus, to prevent a decrease in the ink repellency. Although the incorporation of the silicone oil in an ink repellent layer improves the ink repellency, the amount of the silicone oil to be added to the silicone rubber layer is preferably 10% by mass or more and 35% by mass or less. When the added amount of the silicone oil is 10% by mass or more, the minute halftone dot reproducibility and the ink repellency are markedly improved. When the added amount is 35% by mass or less, on the other hand, the strength of the silicone rubber layer can be sufficiently secured, and thus, it is possible to maintain the printing durability and the scratch resistance.

The scratch resistance as used herein refers to a resistance to a phenomenon in which scratches or defects are made on the silicone layer during the development or the handling, to cause defects in the resulting printed matter.

In the present invention, the silicone oil refers to a polysiloxane component which is not involved in the crosslinking in the ink repellent layer. Accordingly, it is possible to use a dimethyl silicone oil such as a dimethyl-terminated polydimethylsiloxane, a cyclic polydimethylsiloxane, a dimethyl-terminated polydimethyl-polymethylphenylsiloxane copolymer, or a dimethyl-terminated polydimethyl-polydiphenylsiloxane copolymer. Alternatively, it is also possible to use a modified silicone oil in which a part of methyl groups in its molecule is substituted with any of various types of organic groups, such as a alkyl modified silicone oil, a fluorine modified silicone oil, a polyether modified silicone oil, an alcohol modified silicone oil, an amino modified silicone oil, an epoxy modified silicone oil, an epoxy polyether modified silicone oil, a phenol modified silicone oil, a carboxy modified silicone oil, a mercapto modified silicone oil, an amide modified silicone oil, a carnauba modified silicone oil, or a higher fatty acid modified silicone oil. Further, in the addition polymerization type silicone rubber layer composition, a hydroxyl group-terminated polydimethylsiloxane can be used, because it is not involved in the crosslinking. In the condensation polymerization type silicone rubber layer composition, on the other hand, methyl hydrogen silicone oil can also be used. These silicone oils preferably have a weight average molecular weight, Mw, of from several hundred to 100,000.

In addition to these components, the silicone rubber layer may contain a known filler, such as silica, in order to improve the rubber strength.

Further, the silicone rubber layer preferably contains a colored pigment in order to impart plate inspectability to the planographic printing plate which has been developed. The colored pigment as used herein refers to a pigment capable of absorbing any of light in the visible light wavelength range (from 380 to 780 nm).

In general, pigments are insoluble in a solvent such as water or an aliphatic hydrocarbon. Therefore, when the silicone rubber layer contains a pigment, it is possible to drastically reduce the extraction of coloring matter by water or an organic chemical solution used in the development step, a solvent in the ink used in the printing step, and/or any of various types of washing agents.

The developed planographic printing plate may be inspected, for example, by visual observation, in order to evaluate visual plate inspectability, or inspected by a halftone dot area ratio measuring apparatus, in order to evaluate instrumental plate inspectability. Since an instrumental plate inspection generally has a lower image identification performance as compared to a visual plate inspection, a planographic printing plate having a good instrumental plate inspectability also has a good visual plate inspectability, in many cases.

A common halftone dot area ratio measuring apparatus irradiates any of blue light (having a wavelength of from 400 to 500 nm), green light (having a wavelength of from 500 to 600 nm), red light (having a wavelength of from 600 to 700 nm), or white light (having a wavelength of from 400 to 700 nm) to the halftone dot portions formed on a printing plate, and calculates the halftone dot area ratio from the difference between the quantities of light reflected from the image area and the non-image area. Accordingly, when the difference between the quantities of the light reflected from the image area and the non-image area is small, or when there is no difference therebetween, it is difficult to measure the halftone dot area ratio, and the instrumental plate inspectability is reduced. Many of the organic compounds included in the heat insulating layer or the heat sensitive layer of the planographic printing plate original absorb blue light. Therefore, in the case of using a silicone rubber layer colored with a colored pigment of yellow, or orange which absorbs blue light, the difference between the quantities of the light reflected from the image area and the non-image area is decreased, and the instrumental plate inspectability is reduced. Further, the visual plate inspectability may also be reduced. For this reason, it is preferred to use a colored pigment capable of absorbing green light or red light, in terms of the instrumental plate inspectability and the visual plate inspectability. In addition, among the colored pigments capable of absorbing green light or red light, a colored pigment having a density of 3 g/cm³ or less is preferred, in terms of dispersibility in the silicone rubber layer composition or a solution thereof. Examples of the colored pigment capable of absorbing green light or red light and having a density of 3 g/cm³ or less include: cobalt blue, Milori Blue, hydrous silicate, ultramarine, carbon black, textile printing pigments obtained by dying an extender pigment (such as calcium carbonate powder, settleable calcium carbonate, gypsum, asbestos, clay, silica powder, diatomaceous earth, talc, basic magnesium carbonate, or alumina white) with a dye such as rhodamine, methyl violet, peacock blue, alkali blue, malachite green or alizarin, as well as alkali blue, aniline black, lithol red, Lake Red C, Brilliant Carmine 6B, Watchung Red, Bordeaux 10B, para red, Lake Red 4R, naphthol red, Cromophtal Scarlet RN, phthalocyanine blue, Fast Sky Blue, phthalocyanine green, anthraquinone pigments, perylene red, thioindigo red, indanthrone blue, quinacridone red, quinacridone violet, dioxazine violet, and naphthol green B. Two or more of these pigments may be contained.

In cases where the colored pigment is incorporated into the silicone rubber layer, in the planographic printing plate original according to the present invention, the content of the colored pigment in the silicone rubber layer is preferably 0.1% by volume or more, and more preferably 0.2% by volume or more. At the same time, the content of the colored pigment is preferably 20% by volume or less, and more preferably 10% by volume or less, in terms of maintaining the ink repellency of the silicone rubber layer.

It is preferred that a pigment dispersant be incorporated into the silicone rubber layer composition, in order to improve the dispersibility of the colored pigment in the silicone rubber layer. The incorporation of a pigment dispersant allows for preventing the aggregation of the colored pigment, which occurs when the silicone rubber layer composition is diluted with a solvent, or which occurs in the silicone rubber layer composition or a solution thereof, with the passing of time. The pigment dispersant is preferably one capable of wetting the surface of the pigment effectively, and having a good affinity with organopolysiloxanes and low-polarity compounds such as a solvent to be used for diluting a colored pigment-containing silicone liquid to be described later. Any known pigment dispersant can be used, as long as it is a pigment dispersant as described above. Note that the pigment dispersant is sometimes used under the name of a surfactant, or a surface modifier. Examples of the pigment dispersant include organic complex compounds formed from a metal and an organic compound, amine-based pigment dispersants, acid-based pigment dispersants, and nonionic surfactants. Among these, an organic complex compound formed from a metal and an organic compound, or an amine-based pigment dispersant is preferred.

Examples of metals and organic compounds for forming the organic complex compound include metals and organic compounds for forming the metal complex compound described above as examples of the crosslinking agent used in the heat sensitive layer. In particular, the organic compound is preferably an acid compound such as a carboxylic acid, phosphoric acid or a sulfonic acid; or a diketone, a ketoester or a diester compound capable of forming a chelate ring with a metal, in terms of ability to coordinate to a metal.

The simplest organic complex compound which is used as the pigment dispersant can be obtained by stirring any of the above described organic compounds and a metal alkoxide at room temperature or with heating, to allow exchange of ligands. It is preferred that one or more molecules of the organic compound be coordinated to one metal.

Examples of the organic complex compound formed from a commercially available metal and organic compound will be described below. Examples of the aluminum-based organic complex compound include: "Octope" (registered trademark) Al, "Olipe" AOO and AOS (all of the above manufactured by Hope Chemical Co., Ltd.); and "Plenact" (registered trademark) AL-M (manufactured by Ajinomoto Fine Techno Co., Ltd.). Examples of the titanium-based organic complex compound include: "Plenact" KR-TTS, KR46B, KR55, KR41B, KR38S, KR138S, KR238S, KR338X, and KR9SA (all of the above manufactured by Ajinomoto Fine Techno Co., Ltd.); and "KEN-REACT" (registered trademark) TTS-B, 5, 6, 7, 10, 11, 12, 15, 26S, 37BS, 43, 58CS, 62S, 36B, 46B, 101, 106, 110S, 112S, 126S, 137BS, 158DS, 201, 206, 212, 226, 237, and 262S (all of the above manufactured by Kenrich Petrochemicals, Inc.).

The above described organic complex compounds can be suitably used in an addition reaction type silicone rubber layer, in particular. Among these, an organic complex compound which does not contain any of primary and secondary amines, phosphorus, and sulfur within its molecule does not act as a catalyst poison for a platinum catalyst, and thus, it is extremely suitable for use in an addition reaction type silicone rubber layer, for the curing of which a platinum catalyst is used.

As the amine-based pigment dispersant, either a monoamine-type dispersant containing one amino group within its molecule, or a polyamine-type dispersant containing a plurality of amino groups within its molecule, can be suitably used. Specific examples thereof include "Solsperse" (registered trademark) 9000, 13240, 13650, 13940, 17000, 18000, 19000, and 28000 (all of the above manufactured by Lubrizol Corporation).

It is preferred that the silicone rubber layer composition contain the pigment dispersant in an amount, with respect to the surface area of the pigment, of from 2 to 30 mg/m². In other words, when the composition contains 10 g of a pigment having a specific surface area of 50 m²/g, for example, the content of the pigment dispersant is preferably from 1 to 15 g.

In the planographic printing plate original according to the present invention, the silicone rubber layer preferably has an average film thickness of from 0.5 to 20 µm. When the silicone rubber layer has an average film thickness of 0.5 µm or more, the resulting printing plate has a sufficient ink repellency, scratch resistance, and/or printing durability. At the same time, when the silicone rubber layer has an average film thickness of 20 µm or less, no disadvantage occurs from the viewpoint of economic efficiency, and a decrease in the developability and inking quantity is less likely to occur. The average film thickness of the silicone rubber layer as used herein can be obtained by TEM observation. More specifically, the film thickness can be measured by preparing a sample from the planographic printing plate original by an ultrathin sectioning, and carrying out TEM observation of the sample at an accelerating voltage of 100 kV and a direct magnification of 2,000-fold. The average film thickness can be obtained by measuring the film thickness at randomly selected 10 points in the silicone rubber layer, and by calculating the number average value of the measured values.

For the purpose of protecting the silicone rubber layer of the planographic printing plate original according to the present invention, it is possible to form and/or to provide a protective film and/or an interleaving paper, or a protective film such as one disclosed in JP 2013-221045 A, for example, on the upper portion of the silicone layer.

The protective film is preferably a film having a thickness of 100 µm or less and capable of effectively transmitting the wavelength of the light of the exposure light source. Typical examples include films of polyethylene, polypropylene, polyvinyl chloride, polyethylene terephthalate, and cellophane. Further, the protective film may include thereon any of various types of light absorbers, photobleachable materials and photochromic materials, such as those described in JP Hei 2-063050 A, for the purpose of preventing the exposure of the printing original due to being exposed to light.

The interleaving paper preferably has a weight per unit area of from 30 to 120 g/m², and more preferably from 30 to 90 g/m². When the interleaving paper has a weight per unit area of 30 g/m² or more, a sufficient mechanical strength can be obtained. When the interleaving paper has a weight per unit area of 120 g/m² or less, on the other hand, it is advantageous not only in terms of economic efficiency, but also in terms of operation efficiency since the thickness of the resulting laminate of the planographic printing plate original and the paper is reduced. Examples of preferred interleaving papers include information recording paper 40 g/m² (manufactured by Nagoya Pulp K.K.), metal-containing interleaving paper 30 g/m² (manufactured by Nagoya Pulp K.K.), unbleached kraft paper 50 g/m² (manufactured by Chuetsu Pulp & Paper Co., Ltd.), NIP paper 52 g/m² (manufactured by Chuetsu Pulp & Paper Co., Ltd.), pure white roll paper 45 g/m² (manufactured by Oji Paper Co., Ltd.), and Clupak 73 g/m² (manufactured by Oji Paper Co., Ltd.), but not limited thereto.

Next, the method of producing the planographic printing plate original according to the present invention will be described. The method of producing the planographic printing plate original according to the present invention includes at least a step of forming a heat sensitive layer and a step of forming a silicone rubber layer, on a substrate. The method may further include other steps. For example, the step of forming a heat sensitive layer may be (a) a step of coating a heat sensitive layer composition or a heat sensitive layer composition solution on a substrate which may include a heat insulating layer, followed by drying as necessary, to form a heat sensitive layer. Further, the step of forming a silicone rubber layer may be (b) a step of coating a silicone rubber layer composition or a silicone rubber layer composition solution on the heat sensitive layer, followed by drying as necessary, to form a silicone rubber layer.

A description will be given below regarding (a) the step of coating a heat sensitive layer composition or a heat sensitive layer composition solution on a substrate which may include a heat insulating layer, followed by drying as necessary, to form a heat sensitive layer.

In cases where the heat sensitive layer is formed by coating a heat sensitive layer composition, the heat sensitive layer composition is a solventless liquid composed of materials constituting the heat sensitive layer, and the composition can be prepared by mixing the components constituting the heat sensitive layer, and other components, as necessary.

The heat sensitive layer composition or the heat sensitive layer composition solution may be directly coated on a substrate, or alternatively, the heat sensitive layer composition solution may be coated on a substrate which includes a resin layer such as a heat insulating layer, as necessary. It is preferred that the surface to be coated of the substrate be degreased in advance.

The coating can be carried out, for example, using a coating apparatus such as: a slit die coater, a direct gravure coater, an offset gravure coater, a reverse roll coater, a natural roll coater, an air knife coater, a roll blade coater, a Vari-Bar roll blade coater, a two-stream coater, a rod coater, a dip coater, a curtain coater, or a spin coater. Among these, a slit die coater, a gravure coater or a roll coater is particularly preferred, in terms of film coating accuracy, productivity and cost.

The coating weight of the heat sensitive layer composition solution, as measured after drying, is suitably within the range of from 0.1 to 10 g/m², and preferably within the range of from 0.5 to 7 g/m², because it serves to improve the printing durability of the printing plate, and facilitates the volatilization of the diluting solvent to achieve excellent productivity. The heat sensitive layer composition solution is dried with or without heating. In cases where the heat sensitive layer is dried with heating, the drying is carried out using a hot air dryer, or an infrared dryer, at a heat drying temperature of preferably 30°C or higher and 190°C or lower, in terms of the minute halftone dot reproducibility and the solvent resistance. The lower limit of the heat drying temperature is more preferably 50°C or higher, and the upper limit thereof is more preferably 150°C or lower. The drying is carried out preferably for a period of from 30 seconds to 5 minutes.

Next, a description will be given below regarding (b) the step of coating a silicone rubber layer composition or a silicone rubber layer composition solution on the heat sensitive layer, followed by drying as necessary, to form a silicone rubber layer. The silicone rubber layer composition as used herein is a solventless liquid composed of materials constituting the silicone rubber layer, and the silicone rubber layer composition solution is a dilute solution containing the silicone rubber layer composition and a solvent.

Examples of the solvent used for dispersing the colored pigment or used in the silicone rubber layer composition solution include: aliphatic saturated hydrocarbons, aliphatic unsaturated hydrocarbons, alicyclic hydrocarbons, halogenated hydrocarbons, and ethers. These solvents preferably has a solubility parameter of 17.0 (MPa)^{1/2} or less, and more preferably 15.5 (MPa)^{1/2} or less. Examples thereof include: aliphatic saturated hydrocarbons such as hexane, heptane, octane, nonane, decane, undecane, dodecane, isooctane, "Isopar" (registered trademark) C, "Isopar" E, "Isopar" G, "Isopar" H, "Isopar" K, "Isopar" L, and "Isopar" M (all "Isopar" series manufactured by Exxon Mobile Corporation); aliphatic unsaturated hydrocarbons such as hexene, heptene, octene, nonene, and decene; alicyclic hydrocarbons such as cyclopentane, cyclohexane, and methylcyclohexane; halogenated hydrocarbons such as trifluorotrichloroethane; and ethers such as diethyl ether, diisopropyl ether, and diisobutyl ether. Two or more of these solvents may be used. Aliphatic and alicyclic hydrocarbons are preferred in terms of economic efficiency and safety. Among these, aliphatic and alicyclic hydrocarbons having from 4 to 20 carbon atoms are preferred, and those having from 6 to 15 carbon atoms are more preferred.

Specific methods for preparing (i) the silicone rubber layer composition, and (ii) the silicone rubber layer composition solution will be described below.

### (i) Silicone Rubber Layer Composition (Solventless)

For example, a hydroxyl group- or vinyl group-containing organopolysiloxane, and a colored pigment, a pigment dispersant and microparticles, as required, are uniformly dispersed and mixed using a disperser, to obtain a silicone paste. The disperser may be, for example, a three-roll mill, a ball mill, a bead mill, a sand mill, a disperser, a homogenizer, an attritor, or an ultrasonic wave disperser. To the resulting silicone paste, a crosslinking agent, a reaction catalyst, and other additives (such as reaction inhibitor) as necessary, are added. The resultant is then stirred to uniformly mix the respective components, and to remove air bubbles mixed in the liquid, thereby obtaining a silicone rubber layer composition. The removal of air bubbles may be performed by natural degassing or vacuum degassing.
However, it is more preferably performed by vacuum degassing.

### (ii) Silicone Rubber Layer Composition Solution (Containing Solvent)

For example, a hydroxyl group- or vinyl group-containing organopolysiloxane, and a colored pigment, a pigment dispersant and microparticles, as required, are uniformly dispersed and mixed using any of dispersers described above, to obtain a silicone paste. The resulting paste is diluted with a solvent while stirring. The resulting solution is preferably filtered with a common filter made of paper, plastic, or glass, to remove impurities (such as large particles of insufficiently dispersed colored pigment) in the dilute solution. It is preferred that the dilute solution after the filtration be subjected to bubbling with dry air, or dry nitrogen, to remove water contained in the system. To the dilute solution from which water has been sufficiently removed, a crosslinking agent, a reaction catalyst, and other additives (such as reaction inhibitor) as necessary, are added. The resultant is then stirred to uniformly mix the respective components, and to remove air bubbles mixed in the solution. The removal of air bubbles may be performed by natural degassing or vacuum degassing.

Further, another method for preparing the silicone rubber layer composition solution containing a colored pigment may be, for example, a method in which a colored pigment dispersion and a silicone liquid or a diluted silicone solution is separately prepared in advance, and then mixing both the liquids. The colored pigment dispersion can be obtained by adding to a solution containing at least a pigment dispersant and a solvent, a colored pigment, and microparticles, as necessary, and then uniformly dispersing and mixing the resultant using any of the dispersers described above. The silicone liquid can be obtained by mixing a hydroxyl group- or vinyl group-containing organopolysiloxane, a crosslinking agent, a reaction catalyst, and other additives (such as reaction inhibitor) as necessary. Further, the diluted silicone solution can be obtained by diluting the resulting silicone liquid with a solvent.

When carrying out the coating of the silicone rubber layer composition or the silicone rubber layer composition solution, it is preferred to remove water attached to the surface of the heat sensitive layer, as far as possible, in terms of improving the adhesion. Specifically, the removal of water may be carried out, for example, by coating the silicone rubber layer composition or the silicone rubber layer composition solution in a space where water is removed by filling the space with a dry gas, or by continuously supplying the dry gas thereinto. Any of the same coating apparatuses as those used for the coating of the heat sensitive layer can be used.

In the case of coating the silicone rubber layer composition solution, the coated silicone rubber layer composition solution is then dried, to form a silicone rubber layer. A heat treatment may be performed for drying and curing. It is preferred that the silicone rubber layer composition and the silicone rubber layer composition solution be heated immediately after the coating, in terms of the curability and the adhesion to the heat sensitive layer.

The resulting planographic printing plate original is preferably stored with a protective film and/or an interleaving paper provided thereon, in terms of protecting the plate surface.

Next, a description will be given below regarding an example of the method of producing a planographic printing plate from the planographic printing plate original according to the present invention.

The planographic printing plate as used herein refers to a planographic printing plate which includes an image area formed with an ink accepting layer and a non-image area formed with an ink repellent layer, and in which the image area and the non-image area are provided substantially on the same plane. When carrying out printing using the planographic printing plate, the difference in the ink adhesion between the image area and the non-image area is utilized to allow an ink to adhere only on the image area, and the adhered ink is then transferred to an object to be printed, such as a paper, to achieve printing.

In the printing using a waterless planographic printing plate, a higher scumming start temperature leads to a reduced necessity for strict temperature control, and thereby facilitates the temperature control during the printing. The scumming refers to a phenomenon in which an ink remains in the non-image area of a printing plate, and the ink is transferred to a portion(s) of an object to be printed where the adhesion of ink is not intended. In a waterless printing, a higher temperature of the plate surface leads to an increased occurrence of the scumming. Therefore, if the occurrence of the scumming can be prevented, it is possible to perform stable printing. Since the waterless printing requires no control of water, it is thought that the waterless printing allows for carrying out printing more easily as compared to printing techniques which use water, particularly when performing printing on a non-absorbable material, such as a plastic sheet or a surface treated paper. The scumming start temperature is preferably 30°C or higher, and more preferably 32°C or higher, although it varies depending on the printing environment. When the scumming start temperature is 30°C or higher, it is possible to carry out printing without the occurrence of scumming. When the scumming start temperature is 32°C or higher, a strict temperature control is not required, and thus the printing can be carried out more easily.

Further, the incorporation of the polyurethane into the heat sensitive layer allows for imparting cushioning characteristics to the layer, thereby providing a higher printing durability. The printing durability refers a state where an adequate printing cannot be performed, as a result of abrasion or peeling of the silicone layer due of repeated printing.

The method of producing a planographic printing plate is characterized by including the step of irradiating a laser beam to the planographic printing plate original according to the present invention, followed by applying physical stimulation to the planographic printing plate original.

First, the step of irradiating a laser beam will be described. The planographic printing plate original according to the present invention is exposed imagewise to a laser beam which is scanned according to digital data. In cases where the planographic printing plate original includes a protective film, the plate original may be exposed through the protective film, or the protective film may be peeled off before the exposure. A laser light source to be used in the exposure step may be, for example, one having an emission wavelength in the range of from 300 nm to 1,500 nm. In particular, a semiconductor laser or a YAG laser having an emission wavelength close to the near-infrared region is preferably used. Specifically, a laser beam having a wavelength of 780 nm, 830 nm, or 1,064 nm is preferably used for exposure, in terms of the handleability of the plate original in a light room.

Next, the step of applying physical stimulation to the planographic printing plate original which has been subjected to laser irradiation will be described. The application of physical stimulation allows for removing the portions of the silicone rubber layer irradiated with the laser beam. The physical stimulation may be applied, for example, by (i) a method in which a nonwoven fabric, an absorbent cotton, a cloth, or a sponge impregnated with a developer is used to wipe off the planographic printing plate original surface; (ii) a method in which the planographic printing plate original surface is pre-treated with a developer, and then scrubbed with a rotatable brush while showering with tap water; or (iii) a method in which water or warm water under high pressure, or water vapor, is injected to the planographic printing plate original surface.

Further, it is possible to add a step of treating the planographic printing plate original which has been subjected to laser irradiation with a treatment liquid, before or after carrying out the step of applying physical stimulation to the planographic printing plate original according to the present invention. In the exposed planographic printing plate original, the exposed portions of the heat sensitive layer surface can be dissolved with a pre-treatment liquid. The pre-treatment liquid may be, for example: water; water to which a polar solvent such as an alcohol, a ketone, an ester, or a carboxylic acid is added; a solvent composed of at least one of an aliphatic hydrocarbon, and an aromatic hydrocarbon, to which a polar solvent is added; or a polar solvent. Further, a known surfactant can also be added freely to the above described developer composition. The surfactant is preferably one whose aqueous solution has a pH of from 5 to 8, in terms of safety, and cost for disposal. The content of the surfactant is preferably 10% by mass or less with respect to the amount of the developer. Such a developer is preferred, because of its high safety, and also in terms of economic efficiency such as the cost of disposal. In addition, it is preferred that a glycol compound or a glycol ether compound be used as a main component, and it is more preferred that an amine compound be allowed to coexist therewith.

As the pre-treatment liquid and the developer, the pre-treatment liquids and developers described in JP 63-179361 A, JP 4-163557 A, JP 4-343360 A, JP 9-34132 A, and JP 3716429 B can be used. Specific examples of the pre-treatment liquid include PP-1, PP-3, PP-F, PP-FII, PTS-1, PH-7N, CP-1, NP-1, DP-1, and CP-Y (all of the above manufactured by Toray Industries, Inc.). Such a pre-treatment liquid is used to dissolve the portions of the heat sensitive layer surface irradiated with the laser beam.

For the purpose of enhancing the visibility of the image area and the accuracy of measuring halftone dots, it is possible to add a dye such as Crystal Violet, Victoria Pure Blue or Astrazon Red to any of the above described developers, so that the dyeing of the ink accepting layer forming the image area can be carried out simultaneously with the development. Further, it is also possible to carry out the dyeing after the exposure, using a liquid to which any of the above described dyes is added.

A part or the entirety of the development step can be carried out automatically by an automatic developing machine. As the automatic developing machine, it is possible to use: an apparatus consisting of a development unit; an apparatus in which a pre-treatment unit and a development unit are provided in this order; an apparatus in which a pre-treatment unit, a development unit, and a post-treatment unit are provided in this order; an apparatus in which a pre-treatment unit, a development unit, a post-treatment unit, and a water-washing unit are provided in this order. Specific examples of such an automatic developing machine include TWL-650 series, TWL-860 series, and TWL-1160 series (all of the above manufactured by Toray Industries, Inc.); and the automatic developing machines disclosed in JP 4-2265 A, JP 5-2272 A, and JP 5-6000 A. These automatic developing machines may be used in combination.

In cases where the developed planographic printing plates are stacked for storage, it is preferred that interleaving papers be placed between the respective printing plates, in order to protect the plate surface.

In the developed planographic printing plate, the image area having ink acceptability and the non-image area having ink repellency are provided substantially on the same plane, and the difference in the ink adhesion between the image area and the non-image area can be utilized to allow an ink to adhere only to the image area. At this time, it is possible to use not only an ink (oil-based ink) which can be dried by air-blowing, but also an ink (UV ink or LED ink) capable of being cured by the irradiation of an active energy ray. The active energy ray may be, for example, visible light, UV light, infrared ray, X-ray, α-ray, β-ray, or γ-ray. However, the irradiation of UV light is preferred, because it allows for a reaction to proceed at a high rate, and an energy ray generator therefor is available at a relatively low cost. UV light generally refers to an electromagnetic wave having a wavelength of from 100 to 400 nm. As the light source, a high pressure mercury lamp, a metal halide lamp, or a UV-LED lamp can be used, but not particularly limited thereto. Among these light sources, a UV-LED lamp capable of irradiating light having a wavelength within the range of from 300 nm to 450 nm is preferred, in terms of power consumption. By using a method in which the adhered ink is directly transferred to an object to be printed, such as paper, or by using an offset printing method in which the ink is transferred via a blanket, it is possible to form an arbitrary image on an object to be printed, thereby producing a printed matter.

### EXAMPLES

The present invention will now be described in further detail, with reference to Examples. Evaluations in the respective Examples and Comparative Examples were carried out by the following methods.

### (1) TEM Observation of Planographic Printing Plate Original

A sample was prepared from a planographic printing plate original before being subjected to laser irradiation, by ultrathin sectioning. Using a transmission electron microscope: H-1700FA (manufactured by Hitachi High-Technologies Corporation), the cross section of the heat sensitive layer was observed at an accelerating voltage of 100 kV and at a magnification of 2,000-fold. The average film thicknesses of the protective film, the silicone rubber layer, the heat sensitive layer, and the heat insulating layer were obtained according to the following measuring methods.

### (1-1) Average Film Thicknesses of Protective Film, Silicone Rubber Layer, Heat Sensitive Layer, and Heat Insulating Layer

The film thicknesses of the protective film, the silicone rubber layer, the heat sensitive layer, and the heat insulating layer were measured, at randomly selected 10 points in a TEM photograph of a vertical cross section of the sample of the planographic printing plate original, obtained by ultrathin sectioning. Then the number average values of the thicknesses of the respective film and layers were calculated, to be taken as the average film thicknesses thereof.

### (2) Evaluation of Sensitivity

### (2-1) Laser Irradiation Conditions

The resulting planographic printing plate original (1,030 × 800 mm) was set in an exposure machine "PlateRite" 8800E (manufactured by SCREEN Graphic Solutions Co., Ltd.), and laser irradiation was carried out at an irradiation energy of 120 mJ/cm² to form a positive image with a resolution of 2,400 dpi (175 lines), namely, to form 100 each of the following three types of halftone dots: a smallest halftone dot (0.5%) having a size of 10 µm × 10 µm; a halftone dot (1.0%) consisting of two of the 0.5%-halftone dots which are laterally adjacent; and a halftone dot (2.0%) consisting of four of the 0.5%-halftone dots which are laterally and vertically adjacent. The dot (%) as used herein refers to the size of a halftone dot.

### (2-2) Conditions for Development Using Automatic Developing Machine

The planographic printing plate original which had been subjected to laser irradiation, obtained by the method (2-1) described above, was developed using an automatic developing machine "TWL-1160F" (manufactured by Toray Industries, Inc.), under the following conditions.
Pre-treatment liquid (45°C): CP-Y (manufactured by Toray Industries, Inc.)
Developer (room temperature): tap water
Post-treatment liquid (room temperature): PA-1 (manufactured by Toray Industries, Inc.)
Plate feed rate: 80 cm/min

Note, however, in Example 6 alone, that the development was carried out under the following conditions.
Pre-treatment liquid (45°C): CP-Y (manufactured by Toray Industries, Inc.)
Developer (room temperature): tap water
Post-treatment liquid (room temperature): tap water
Plate feed rate: 80 cm/min

In the printing plate obtained by exposure and development, the number of halftone dots in which the silicone rubber layer had peeled off was counted, for each of the above described three types of halftone dots. The evaluation was performed based on the criteria that the larger the number of the peeling of the silicone rubber layer, the better the halftone dot reproducibility. When the printing plate had a reproducibility of the 2.0%-dot, consisting of four 0.5%-halftone dots, of 100% or more, the printing plate was determined to be practically usable.

### (3) Printing Conditions

### (3-1) Oil-based Printing

The printing plate obtained by the above described method (2-2) was set in a offset printing machine Komori Sprint Four-Color Machine (manufactured by KOMORI Corporation), and a printing test was carried out using "Alpo" (registered trademark) GT manufactured by T&K TOKA Corporation. The feed rate of the oil-based ink was controlled such that the reflection density of the solid printed portion was 1.8 (black), and a thin paper (coated paper) to which the oil-based ink had been transferred was dried by blowing air, to obtain a printed matter.

### (3-2) UV Printing

Using "UV171CT-TW" manufactured by T&K TOKA Corporation, a printing test was carried out by a printing machine "Oliver 266 EPZ" (manufactured by Sakurai Graphic Systems Corporation), to the paper discharging portion of which a UV light irradiation apparatus including a built-in speed variable conveyor had been connected. The feed rate of the UV ink was controlled such that the reflection density of the solid printed portion was 1.8 (black), and an active energy ray was irradiated to a thin paper (coated paper) to which the UV ink had been transferred, to obtain a printed matter.

### (3-3) LED UV Printing

Using "Rich cure WL LED" manufactured by Naigai Ink Mfg. Co., Ltd., a printing test was carried out by a printing machine "Oliver 266 EPZ" (manufactured by Sakurai Graphic Systems Corporation), to the paper discharging portion of which an irradiation apparatus including a built-in speed variable conveyor and capable of irradiating an active energy ray having a wavelength of from 300 to 450 nm had been connected. The feed rate of the LED UV ink was controlled such that the reflection density of the solid printed portion was 1.8 (black), and an active energy ray having a wavelength of from 300 to 450 nm was irradiated to a thin paper (coated paper) to which the LED UV ink had been transferred, to obtain a printed matter.

### (4) Measurement of Scumming Start Temperature

In the printing according to the above described (3), a chiller was used to control the temperature of the ink roller, and thereby varied the plate surface temperature of the waterless planographic printing plate. The plate surface temperature was measured by a non-contact thermometer, and the scumming of the non-image area was checked at every measured temperature.

### (5) Evaluation of Printing Resistance

In the printing according to the above described (3), black, indigo blue, red, and yellow inks and a wood-free paper (62.5 g/octavo) were used. The fouling of the printed matter, and the damage state of the silicone rubber layer and the photosensitive layer of the plate surface after the completion of the printing, were evaluated by visual observation.

### (6) Evaluation of Thermal Decomposability of Heat Sensitive Layer

The measurement of the thermal decomposability was carried out, using Macro Thermogravimetric Analyzer TGA-50 (hereinafter, referred to as TGA) (manufactured by SHIMADZU CORPORATION). The measurement was carried out by increasing the temperature according to the following procedure, and by measuring the temperature at which the weight reduction ratio (100 - (weight at a predetermined temperature / initial weight) * 100) reaches 30% or more (hereinafter referred to as thermal decomposition temperature).

The temperature in the TGA was increased at a heating temperature of 20°C/min, and maintained at 100°C for 20 min. Then the temperature was increased at a heating temperature of 20°C/min and maintained at 200°C for 20 min. Further, the temperature was increased at a heating temperature of 10°C/min and maintained at 590°C for 1 min (measurement conditions: under pressure, 20°C, 20 ml (mL/min)).

### (7) Evaluation of Scratch Resistance

The non-image area of the printed matter obtained in the printing described in the above (3) was checked, to confirm the presence or absence of defects.

### (Synthesis Example 1) Synthesis of Polyurethane A

To a round bottom flask made of glass and equipped with a rectifying column, an agitator, a thermometer and a nitrogen-introducing pipe, 100 parts by mass of ethylene carbonate, 100 parts by mass of 1,4-butanediol, and 20 parts by mass of 1,6-hexanediol were charged, while introducing nitrogen gas to the glass flask. The resultant was mixed at room temperature, while adding 0.02 parts by mass of titanium tetrabutoxide as a catalyst, to make the system homogeneous. Then the reaction was allowed to proceed for 20 hours, while gradually increasing the temperature in the system from 150°C to 160°C. Subsequently, the pressure was reduced to 0.5 kPa, and the reaction was allowed to proceed for another 10 hours at 170°C, while removing diol and ethylene carbonate by distillation, to obtain a polycarbonate diol A (number average molecular weight: 2,000), having 4 carbon atoms in the main chain.

To a round bottom flask made of glass and equipped with a rectifying column, an agitator, a thermometer and a nitrogen-introducing pipe, 200 parts by mass of the polycarbonate diol A and 20 parts by mass of 1,4-butanediol (manufactured by Wako Pure Chemical Industries, Ltd.) were charged, while introducing nitrogen gas to the glass flask, followed by stirring under atmospheric pressure. Further, 60 parts by mass of methyl ethyl ketone was added to the resultant, followed by mixing at room temperature to make the system homogeneous, and to adjust the temperature in the system to 50°C. Subsequently, 20 parts by mass of isophorone diisocyanate (manufactured by Wako Pure Chemical Industries, Ltd.) was charged, and the reaction was allowed to proceed at 80°C for 4 hours. To the resultant, 275 parts by mass of methyl ethyl ketone, and 335 parts by mass of cyclohexanone were further added. As a result, a polyurethane B solution (resin concentration: 30%) was obtained, in which the polycarbonate diol A and butanediol were used as polyols and isophorone diisocyanate was used as a polyisocyanate. The resulting polyurethane A solution was diluted with tetrahydrofuran to a resin concentration of 10%, and dried for 2 hours with a hot air dryer at 150°C, to obtain a polyurethane B (resin concentration: 100%).

### (Synthesis Example 2) Synthesis of Polyurethane B

To a round bottom flask made of glass and equipped with a rectifying column, an agitator, a thermometer and a nitrogen-introducing pipe, 200 parts by mass of ETERNACOLL UH-200 (1,6-hexanediol-based polycarbonate diol, number average molecular weight: 2,000) (manufactured by Ube Industries, Ltd.) and 20 parts by mass of 1,4-butanediol (manufactured by Wako Pure Chemical Industries, Ltd.) were charged, while introducing nitrogen gas to the glass flask, followed by stirring under atmospheric pressure. Further, 60 parts by mass of methyl ethyl ketone was added to the resultant, followed by mixing at room temperature to make the system homogeneous, and to adjust the temperature in the system to 50°C. Subsequently, 20 parts by mass of isophorone diisocyanate (manufactured by Wako Pure Chemical Industries, Ltd.) was charged, and the reaction was allowed to proceed at 80°C for 4 hours. To the resultant, 275 parts by mass of methyl ethyl ketone, and 335 parts by mass of cyclohexanone were further added. As a result, a polyurethane A solution (resin concentration: 30%) was obtained, in which polyhexamethylene carbonate diol and butanediol were used as polyols, and isophorone diisocyanate was used as a polyisocyanate. The resulting polyurethane B solution was diluted with tetrahydrofuran to a resin concentration of 10%, and dried for 2 hours with a hot air dryer at 150°C, to obtain a polyurethane A (resin concentration: 100%).

### (Reference Example 1¹)

A planographic printing plate original was produced according to the following method which includes the step of drying a heat sensitive layer composition solution containing a heat sensitive layer composition.

On a degreased aluminum substrate (manufactured by Mitsubishi Aluminum Co., Ltd.) having a thickness of 0.24 mm, the following heat insulating layer composition solution was coated, to form a heat insulating layer.

### < Heat Insulating Layer Composition Solution >

(a) Bisphenol A-type epoxy resin: "Epicoat" (registered trademark) 1010 (manufactured by Japan Epoxy Resins Co., Ltd.): 35 parts by mass
(b) Polyurethane having an ester structure: "Sanprene" (registered trademark) LQ-T1331D (manufactured by Sanyo Chemical Industries Ltd.): 75 parts by mass
(c) Aluminum trisethylacetoacetate: ALCH-TR (manufactured by Kawaken Fine Chemicals Co., Ltd.): 10 parts by mass
(d) Hydrocarbon surfactant: "Disparlon" (registered trademark) LC951 (manufactured by Kusumoto Chemical Co., Ltd.): 0.1 parts by mass
(e) Titanium oxide: "Tipaque" (registered trademark) CR-50 (manufactured by Ishihara Sangyo Co., Ltd.: 30 parts by mass
(f) N,N-dimethylformamide: 960 parts by mass
(g) Methyl ethyl ketone: 350 parts by mass

Subsequently, the following heat sensitive layer composition solution-1 was coated on the heat insulating layer, to form a heat sensitive layer.

### < Heat Sensitive Layer Composition Solution-1 >

(a) Cyanine compound: YKR2016 (manufactured by Yamamoto Chemicals Inc.): 10 parts by mass
(b) Organic complex compound: titanium-n-butoxide-bis(acetylacetonate): "Na̅cem" (registered trademark) titanium (manufactured by Nippon Kagaku Sangyo Co., Ltd.): 10 parts by mass
(c) Phenol formaldehyde novolac resin: "Sumilite Resin" (registered trademark) PR53195 (Sumitomo Bakelite Co., Ltd.): 60 parts by mass
(d) Polyurethane: polyurethane A obtained in Synthesis Example 1 (resin concentration: 100%), (carbonate structure; number of carbon atoms in the main chain: 4): 20 parts by mass
(e) Tetrahydrofuran: 900 parts by mass

Next, the following silicone rubber layer composition solution prepared immediately before the coating was applied on the heat sensitive layer, to obtain a planographic printing plate original.

### < Silicone Rubber Layer Composition Solution-1 >

(a) α,ω-divinylpolydimethylsiloxane: "TF" 22 (weight average molecular weight: 100,000; manufactured by Dow Corning Toray Co., Ltd.): 90.0 parts by mass
(b) Silicone oil: KF-96-50cs (viscosity average molecular weight: 3,780; manufactured by Shin-Etsu Chemical Co., Ltd.): 0.0 parts by mass
(c) Methylhydrogensiloxane HMS305 (manufactured by Gelest, Inc.): 2.95 parts by mass
(d) Vinyltris(methylethylketoxyimino)silane: 0.88 parts by mass
(e) Platinum catalyst SRX212 (manufactured by Dow Corning Toray Co., Ltd.): 6.17 parts by mass
(f) " Isopar" E (manufactured by Exxon Mobil Corporation): 900 parts by mass

The following components (a) to (c) were mixed and dispersed with a bead mill "Star Mill" (registered trademark) MINI CER (manufactured by Ashizawa Finetech Ltd.) filled with zirconia beads (diameter: 0.3 mm), to obtain a Milori Blue dispersion. At the same time, the following components (d) to (h) were mixed to obtain a diluted silicone solution. While stirring the Milori Blue dispersion, the diluted silicone solution was added thereto, and the mixture was thoroughly stirred until the resultant becomes homogeneous. The resulting solution was naturally degassed.
(a) N650 Milori Blue (manufactured by Dainichiseika Color & Chemicals Mfg. Co., Ltd.): 4 parts by mass
(b) "Plenact" (registered trademark) KR-TTS (manufactured by Ajinomoto Fine Techno Co., Ltd.): 1.5 parts by mass
(c) " Isopar" (registered trademark) G (manufactured by Exxon Mobil Corporation): 83 parts by mass
(d) α,ω-divinylpolydimethylsiloxane: DMS-V52 (weight average molecular weight: 155,000; manufactured by Gelest, Inc.): 83 parts by mass
(e) Methylhydrogensiloxane SH1107 (manufactured by Dow Corning Toray Co., Ltd.): 4 parts by mass
(f) Vinyltris(methylethylketoxyimino)silane: 3 parts by mass
(g) Platinum catalyst SRX212 (manufactured by Dow Corning Toray Co., Ltd.): 6 parts by mass
(h) " Isopar" E (manufactured by Exxon Mobil Corporation): 817 parts by mass.

The thus prepared planographic printing plate original was exposed according to the method described in the above (2-1), and then developed according to the method described in the above (2-2). As a result, the following halftone dot reproducibility was obtained: the number the 0.5%-halftone dots reproduced: 0; the number the 1.0%-halftone dots reproduced: 100; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 50,000 sheets. In addition, the thermal decomposition temperature of the heat sensitive layer was measured according to the method described in the above (6), and the thermal decomposition temperature was 310°C. Then the scratch resistance was evaluated according to the method described in the above (7), and it was confirmed that there was no defect in the non-image area. Compared to the results obtained in Comparative Example 1, the thermal decomposition temperature was confirmed to be 20°C lower. It was also confirmed that 100 more of the 1.0%-minute halftone dots were reproduced, and 40 more of the 2.0%-minute halftone dots were reproduced. Further, the printing durability was confirmed to be 40,000 sheets more than that in Comparative Example 1. Other evaluation results were the same as those obtained in Comparative Example 1. The evaluation results are shown in Table 1.

### (Reference Example 2)

A planographic printing plate original was produced and evaluated in the same manner as in Reference Example 1, except that 40 parts by mass of the novolac resin and 40 parts by mass of the polyurethane were used in the heat sensitive layer composition solution-1.

The evaluation of the halftone dot reproducibility was carried out in the same manner as in Reference Example 1, to obtain the following results: the number the 0.5%-halftone dots reproduced: 0; the number the 1.0%-halftone dots reproduced: 80; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 50,000 sheets. In addition, the thermal decomposition temperature of the heat sensitive layer was measured according to the method described in the above (6), and the thermal decomposition temperature was 310°C. Then the scratch resistance was evaluated according to the method described in the above (7), and it was confirmed that there was no defect in the non-image area. Compared to the results obtained in Example 1, it was confirmed that 20 less of the 1.0%-minute halftone dots were reproduced. Other evaluation results were the same as those obtained in Reference Example 1. The evaluation results are shown in Table 1.

### (Reference Example 3)

A planographic printing plate original was produced and evaluated in the same manner as in Reference Example 1, except that 70 parts by mass of the novolac resin and 10 parts by mass of the polyurethane were used in the heat sensitive layer composition solution-1.

The evaluation of the halftone dot reproducibility was carried out in the same manner as in Reference Example 1, to obtain the following results: the number the 0.5%-halftone dots reproduced: 0; the number the 1.0%-halftone dots reproduced: 100; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 50,000 sheets. In addition, the thermal decomposition temperature of the heat sensitive layer was measured according to the method described in the above (6), and the thermal decomposition temperature was 310°C. Then the scratch resistance was evaluated according to the method described in the above (7), and it was confirmed that there was no defect in the non-image area. When compared with the results obtained in Reference Example 1, the evaluation results were the same. The evaluation results are shown in Table 1.

### (Reference Example 4)

A planographic printing plate original was produced and evaluated in the same manner as in Reference Example 1, except that 30 parts by mass of the novolac resin and 50 parts by mass of the polyurethane were used in the heat sensitive layer composition solution-1.

The evaluation of the halftone dot reproducibility was carried out in the same manner as in Reference Example 1, to obtain the following results: the number the 0.5%-halftone dots reproduced: 0; the number the 1.0%-halftone dots reproduced: 50; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 50,000 sheets. In addition, the thermal decomposition temperature of the heat sensitive layer was measured according to the method described in the above (6), and the thermal decomposition temperature was 310°C. Then the scratch resistance was evaluated according to the method described in the above (7), and it was confirmed that there was no defect in the non-image area. Compared to the results obtained in Reference Example 1, it was confirmed that 50 less of the 1.0%-minute halftone dots were reproduced. Other evaluation results were the same as those obtained in Reference Example 1. The evaluation results are shown in Table 1.

### (Reference Example 5)

A planographic printing plate original was produced and evaluated in the same manner as in Reference Example 1, except that 75 parts by mass of the novolac resin and 5 parts by mass of the polyurethane were used in the heat sensitive layer composition solution-1.

The evaluation of the halftone dot reproducibility was carried out in the same manner as in Reference Example 1, to obtain the following results: the number the 0.5%-halftone dots reproduced: 0; the number the 1.0%-halftone dots reproduced: 80; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 10,000 sheets. In addition, the thermal decomposition temperature of the heat sensitive layer was measured according to the method described in the above (6), and the thermal decomposition temperature was 310°C. Then the scratch resistance was evaluated according to the method described in the above (7), and it was confirmed that there was no defect in the non-image area. Compared to the results obtained in Reference Example 1, it was confirmed that 20 less of the 1.0%-minute halftone dots were reproduced. It was also confirmed that the printing durability was 10,000 sheets, which was 40,000 sheets less than that in Reference Example 1. Other evaluation results were the same as those obtained in Reference Example 1. The evaluation results are shown in Table 1.

### (Reference Example 6)

A planographic printing plate original was obtained in the same manner as in Reference Example 5, except that the following silicone rubber layer composition solution-2 was used instead of the silicone rubber composition solution-1.

The following components (a) to (c) were mixed and dispersed with a bead mill "Star Mill" (registered trademark) MINI CER (manufactured by Ashizawa Finetech Ltd.) filled with zirconia beads (diameter: 0.3 mm), to obtain a Milori Blue dispersion. At the same time, the components (d) to (h) were mixed to obtain a diluted silicone solution. While stirring the Milori Blue dispersion, the diluted silicone solution was added thereto, and mixture was thoroughly stirred until the resultant becomes homogeneous. The resulting solution was naturally degassed.
(a) N650 Milori Blue (manufactured by Dainichiseika Color & Chemicals Mfg. Co., Ltd.): 4 parts by mass
(b) "Plenact" (registered trademark) KR-TTS (manufactured by Ajinomoto Fine Techno Co., Ltd.): 1.5 parts by mass
(c) " Isopar" (registered trademark) G (manufactured by Exxon Mobil Corporation): 83 parts by mass
(d) α,ω-divinylpolydimethylsiloxane: DMS-V52 (weight average molecular weight: 155,000; manufactured by Gelest, Inc.): 83 parts by mass
(e) Methylhydrogensiloxane SH1107 (manufactured by Dow Corning Toray Co., Ltd.): 4 parts by mass
(f) Vinyltris(methylethylketoxyimino)silane: 3 parts by mass
(g) Platinum catalyst SRX212 (manufactured by Dow Corning Toray Co., Ltd.): 6 parts by mass
(h) " Isopar" E (manufactured by Exxon Mobil Corporation): 817 parts by mass.

The evaluation of the halftone dot reproducibility was carried out in the same manner as in Reference Example 6, to obtain the following results: the number the 0.5%-halftone dots reproduced: 0; the number the 1.0%-halftone dots reproduced: 80; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 10,000 sheets. In addition, the thermal decomposition temperature of the heat sensitive layer was measured according to the method described in the above (6), and the thermal decomposition temperature was 310°C. Then the scratch resistance was evaluated according to the method described in the above (7), and it was confirmed that there was no defect in the non-image area. Compared to the results obtained in Example 1, it was confirmed that 20 less of the 1.0%-minute halftone dots were reproduced. It was also confirmed that the printing durability was 10,000 sheets, which was 40,000 sheets less than that in Reference Example 1. Other evaluation results were the same as those obtained in Reference Example 1. The evaluation results are shown in Table 1.

### (Reference Example 7)

A planographic printing plate original was produced and evaluated in the same manner as in Reference Example 1, except that 20 parts by mass of the novolac resin and 60 parts by mass of the polyurethane were used in the heat sensitive layer composition solution-1. The evaluation of the halftone dot reproducibility was carried out in the same manner as in Reference Example 1, to obtain the following results: the number the 0.5%-halftone dots reproduced: 0; the number the 1.0%-halftone dots reproduced: 0; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 50,000 sheets. In addition, the thermal decomposition temperature of the heat sensitive layer was measured according to the method described in the above (6), and the thermal decomposition temperature was 310°C. Then the scratch resistance was evaluated according to the method described in the above (7), and it was confirmed that there was no defect in the non-image area. Compared to the results obtained in Reference Example 1, it was confirmed that 100 less of the 1.0%-minute halftone dots were reproduced. Other evaluation results were the same as those obtained in Reference Example 1. The evaluation results are shown in Table 1.

### (Example 8)

A planographic printing plate original was obtained in the same manner as in Reference Example 1, except that the following heat sensitive layer composition solution-2 was used instead of the heat sensitive layer composition solution-1.

### < Heat Sensitive Layer Composition Solution-2 >

(a) Cyanine compound: YKR2016 (manufactured by Yamamoto Chemicals Inc.): 10 parts by mass
(b) Organic complex compound: titanium-n-butoxide-bis(acetylacetonate): "Na̅cem" (registered trademark) titanium (manufactured by Nippon Kagaku Sangyo Co., Ltd.): 10 parts by mass
(c) Phenol formaldehyde novolac resin: "Sumilite Resin" (registered trademark) PR53195 (Sumitomo Bakelite Co., Ltd.): 60 parts by mass
(d) Polyurethane: polyurethane B obtained in Synthesis Example 2 (resin concentration: 100%), (carbonate structure; number of carbon atoms in the main chain: 4): 20 parts by mass
(e) Tetrahydrofuran: 900 parts by mass

### < Heat Sensitive Layer Composition Solution-2 >

(a) Cyanine compound: YKR2016 (manufactured by Yamamoto Chemicals Inc.): 8 parts by mass
(b) Organic complex compound: titanium-n-butoxide-bis(acetylacetonate): "Na̅cem" (registered trademark) titanium (manufactured by Nippon Kagaku Sangyo Co., Ltd.): 3 parts by mass
(c) Phenol formaldehyde novolac resin: "Sumilite Resin" (registered trademark) PR53195 (Sumitomo Bakelite Co., Ltd.): 60 parts by mass
(d) Polyurethane: polyurethane B obtained in Synthesis Example 2 (resin concentration: 100%), (carbonate structure; number of carbon atoms in the main chain: 6): 20 parts by mass
(e) Isopar M (manufactured by Exxon Mobil Corporation): 10 parts by weight
(e) Tetrahydrofuran: 900 parts by mass

The evaluation of the halftone dot reproducibility was carried out in the same manner as in Reference Example 1, to obtain the following results: the number the 0.5%-halftone dots reproduced: 50; the number the 1.0%-halftone dots reproduced: 100; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 50,000 sheets. In addition, the thermal decomposition temperature of the heat sensitive layer was measured according to the method described in the above (6), and the thermal decomposition temperature was 290°C. Then the scratch resistance was evaluated according to the method described in the above (7), and it was confirmed that there was no defect in the non-image area. Compared to the results obtained in Example 1, it was confirmed that the thermal decomposition temperature was 20°C lower. It was also confirmed that 50 more of the 0.5%-minute halftone dots were reproduced. Other evaluation results were the same as those obtained in Reference Example 1. The evaluation results are shown in Table 1.

### (Example 9)

A planographic printing plate original was obtained in the same manner as in Example 8, except that 80 parts by mass of the α,ω-divinylpolydimethylsiloxane and 10 parts by mass of the silicone oil were used in the silicone rubber layer composition solution-1.

The evaluation of the halftone dot reproducibility was carried out in the same manner as in Example 8, to obtain the following results: the number the 0.5%-halftone dots reproduced: 100; the number the 1.0%-halftone dots reproduced: 100; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 35°C. Further, printing was carried out according to the method described in the above (5), and it was confirmed that the printing plate had a printing durability of 100,000 sheets. In addition, the thermal decomposition temperature of the heat sensitive layer was measured according to the method described in the above (6), and the thermal decomposition temperature was 290°C. Then the scratch resistance was evaluated according to the method described in the above (7), and it was confirmed that there was no defect in the non-image area. Compared the results obtained in Example 8, it was confirmed that 50 more of the 0.5%-minute halftone dots were reproduced. The printing durability was confirmed to be 100,000 sheets, achieving an increase of 50,000 sheets compared to Example 8. An improvement in the scumming start temperature was also confirmed, achieving an increase of 3°C. Other evaluation results were the same as those obtained in Example 8. The evaluation results are shown in Table 1.

### (Example 10)

A planographic printing plate original was produced in the same manner as in Example 8, except that 55 parts by mass of the α,ω-divinylpolydimethylsiloxane and 35 parts by mass of the silicone oil were used in the silicone rubber layer composition solution-1.

The evaluation of the halftone dot reproducibility was carried out in the same manner as in Example 8, to obtain the following results: the number the 0.5%-halftone dots reproduced: 100; the number the 1.0%-halftone dots reproduced: 100; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 35°C. Further, printing was carried out according to the method described in the above (5), and it was confirmed that the printing plate had a printing durability of 100,000 sheets. In addition, the thermal decomposition temperature of the heat sensitive layer was measured according to the method described in the above (6), and the thermal decomposition temperature was 290°C. Then the scratch resistance was evaluated according to the method described in the above (7), and it was confirmed that there was no defect in the non-image area. Compared to the results obtained in Example 8, it was confirmed that 50 more of the 0.5%-minute halftone dots were reproduced. The printing durability was confirmed to be 100,000 sheets, achieving an increase of 50,000 sheets compared to Example 8. An improvement in the scumming start temperature was also confirmed, achieving an increase of 3°C. Other evaluation results were the same as those obtained in Example 8. The evaluation results are shown in Table 1.

### (Example 11)

A planographic printing plate original was produced in the same manner as in Example 8, except that 40 parts by mass of the α,ω-divinylpolydimethylsiloxane and 50 parts by mass of the silicone oil were used in the silicone rubber layer composition solution-1.

The evaluation of the halftone dot reproducibility was carried out in the same manner as in Example 8, to obtain the following results: the number the 0.5%-halftone dots reproduced: 100; the number the 1.0%-halftone dots reproduced: 100; and the number the 2.0%-halftone dots reproduced: 100. Subsequently, printing was carried out according to the method described in the above (3-1), and the evaluation of the scumming start temperature was carried out according to the method described in the above (4). As a result, it was confirmed that the scumming start temperature was 35°C. Further, printing was carried out according to the method described in the above (5), and it was confirmed that the printing plate had a printing durability of 70,000 sheets. In addition, the thermal decomposition temperature of the heat sensitive layer was measured according to the method described in the above (6), and the thermal decomposition temperature was 290°C. Then the scratch resistance was evaluated according to the method described in the above (7). As a result, defects were observed in the non-image area. Compared to the results obtained in Example 8, it was confirmed that 50 more of the 0.5%-minute halftone dots were reproduced. The printing durability was confirmed to be 70,000 sheets, achieving an increase of 20,000 sheets compared to Example 8. An improvement in the scumming start temperature was also confirmed, achieving an increase of 3°C. Other evaluation results were the same as those obtained in Example 8. The evaluation results are shown in Table 1.

### (Example 12)

Printing was carried out according to the method described in the above (3-2), using the printing plate obtained in Example 8, and the scumming start temperature was evaluated according to the method described in the above (4). As a result, the scumming start temperature was confirmed to be 30°C. Further, printing was carried out according to the method described in the above (5), and it was confirmed that the printing plate had a printing durability of 50,000 sheets. In addition, the thermal decomposition temperature of the heat sensitive layer was measured according to the method described in the above (6), and the thermal decomposition temperature was 290°C. Then the scratch resistance was evaluated according to the method described in the above (7), and it was confirmed that there was no defect in the non-image area. Compared to the results obtained in Example 8, the scumming start temperature was confirmed to be 2°C lower. Other evaluation results were the same as those obtained in Example 8. The evaluation results are shown in Table 1.

### (Example 13)

Printing was carried out according to the method described in the above (3-2), using the printing plate obtained in Example 9, and the scumming start temperature was evaluated according to the method described in the above (4). As a result, the scumming start temperature was confirmed to be 33°C. Further, printing was carried out according to the method described in the above (5), and it was confirmed that the printing plate had a printing durability of 100,000 sheets. In addition, the thermal decomposition temperature of the heat sensitive layer was measured according to the method described in the above (6), and the thermal decomposition temperature was 290°C. Then the scratch resistance was evaluated according to the method described in the above (7), and it was confirmed that there was no defect in the non-image area. Compared to the results obtained in Example 9, the scumming start temperature was confirmed to be 2°C lower. Other evaluation results were the same as those obtained in Example 9. The evaluation results are shown in Table 1.

### (Example 14)

Printing was carried out according to the method described in the above (3-2), using the printing plate obtained in Example 10, and the scumming start temperature was evaluated according to the method described in the above (4). As a result, the scumming start temperature was confirmed to be 33°C. Further, printing was carried out according to the method described in the above (5), and it was confirmed that the printing plate had a printing durability of 100,000 sheets. In addition, the thermal decomposition temperature of the heat sensitive layer was measured according to the method described in the above (6), and the thermal decomposition temperature was 290°C. Then the scratch resistance was evaluated according to the method described in the above (7), and it was confirmed that there was no defect in the non-image area. Compared to the results obtained in Example 10, the scumming start temperature was confirmed to be 2°C lower. Other evaluation results were the same as those obtained in Example 10. The evaluation results are shown in Table 1.

### (Example 15)

Printing was carried out according to the method described in the above (3-3), using the printing plate obtained in Example 9, and the scumming start temperature was evaluated according to the method described in the above (4). As a result, the scumming start temperature was confirmed to be 32°C. Further, printing was carried out according to the method described in the above (5), and it was confirmed that the printing plate had a printing durability of 100,000 sheets. In addition, the thermal decomposition temperature of the heat sensitive layer was measured according to the method described in the above (6), and the thermal decomposition temperature was 290°C. Then the scratch resistance was evaluated according to the method described in the above (7), and it was confirmed that there was no defect in the non-image area. Compared to the results obtained in Example 9, the scumming start temperature was confirmed to be 3°C lower. Other evaluation results were the same as those obtained in Example 9. The evaluation results are shown in Table 1.

### (Example 16)

Printing was carried out according to the method described in the above (3-3), using the printing plate obtained in Example 10, and the scumming start temperature was evaluated according to the method described in the above (4). As a result, the scumming start temperature was confirmed to be 32°C. Further, printing was carried out according to the method described in the above (5), and it was confirmed that the printing plate had a printing durability of 100,000 sheets. In addition, the thermal decomposition temperature of the heat sensitive layer was measured according to the method described in the above (6), and the thermal decomposition temperature was 290°C. Then the scratch resistance was evaluated according to the method described in the above (7), and it was confirmed that there was no defect in the non-image area. Compared to the results obtained in Example 10, the scumming start temperature was confirmed to be 3°C lower. Other evaluation results were the same as those obtained in Example 10. The evaluation results are shown in Table 1.

### (Comparative Example 1)

A planographic printing plate original was obtained in the same manner as in Reference Example 1, except that a heat sensitive layer composition solution-3 was used instead of the heat sensitive layer composition solution-1.

### < Heat Sensitive Layer Composition Solution-3 >

(a) Infrared absorbing dye: YKR2016 (manufactured by Yamamoto Chemicals Inc.): 10 parts by mass
(b) Organic complex compound: titanium-n-butoxide-bis(acetylacetonate): "Na̅cem" (registered trademark) titanium (manufactured by Nippon Kagaku Sangyo Co., Ltd.): 10 parts by mass
(c) Phenol formaldehyde novolac resin: "Sumilite Resin" (registered trademark) PR53195 (Sumitomo Bakelite Co., Ltd.): 75 parts by mass
(d) Polyurethane: "Sanprene" (registered trademark) LQ-T1331 (manufactured by Sanyo Chemical Industries, Ltd.; ester structure, number of carbon atoms in the main chain: 4): 5 parts by mass
(e) Tetrahydrofuran: 900 parts by mass

The evaluation of the halftone dot reproducibility was carried out in the same manner as in Reference Example 2, to obtain the following results: the number the 0.5%-halftone dots reproduced: 0; the number the 1.0%-halftone dots reproduced: 0; and the number the 2.0%-halftone dots reproduced: 60. Subsequently, printing was carried out according to the method described in the above (3-1), and the evaluation of the scumming start temperature was carried out according to the method described in the above (4). As a result, it was confirmed that the scumming start temperature was 32°C. Further, printing was carried out according to the method described in the above (5), and it was confirmed that the printing plate had a printing durability of 10,000 sheets. In addition, the thermal decomposition temperature of the heat sensitive layer was measured according to the method described in the above (6), and the thermal decomposition temperature was 330°C. Then the scratch resistance was evaluated according to the method described in the above (7), and it was confirmed that there was no defect in the non-image area. The evaluation results are shown in Table 1.

### (Comparative Example 2)

A planographic printing plate original was produced and evaluated in the same manner as in Reference Example 1, except that 20 parts by mass of the novolac resin and 60 parts by mass of the polyurethane were used in the heat sensitive layer composition solution-3.

The evaluation of the halftone dot reproducibility was carried out in the same manner as in Reference Example 1, to obtain the following results: the number the 0.5%-halftone dots reproduced: 0; the number the 1.0%-halftone dots reproduced: 0; and the number the 2.0%-halftone dots reproduced: 10. Subsequently, printing was carried out according to the method described in the above (3-1), and the evaluation of the scumming start temperature was carried out according to the method described in the above (4). As a result, it was confirmed that the scumming start temperature was 32°C. Then the scratch resistance was evaluated according to the method described in the above (5), and it was confirmed that there was no defect in the non-image area. In addition, the thermal decomposition temperature of the heat sensitive layer was measured according to the method described in the above (6), and the thermal decomposition temperature was 330°C. Further, the solvent resistance was evaluated according to the method described in the above (7), and it was confirmed that no missing of the silicone layer was observed. The evaluation results are shown in Table 1.

### (Comparative Example 3)

A planographic printing plate original was produced and evaluated in the same manner as in Reference Example 1, except that 75 parts by mass of the novolac resin and 5 parts by mass of the polyurethane were used in the heat sensitive layer composition solution-3.

The evaluation of the halftone dot reproducibility was carried out in the same manner as in Reference Example 1, to obtain the following results: the number the 0.5%-halftone dots reproduced: 0; the number the 1.0%-halftone dots reproduced: 0; and the number the 2.0%-halftone dots reproduced: 60. Subsequently, printing was carried out according to the method described in the above (3-2), and the evaluation of the scumming start temperature was carried out according to the method described in the above (4). As a result, it was confirmed that the scumming start temperature was 30°C. Then the scratch resistance was evaluated according to the method described in the above (5), and it was confirmed that there was no defect in the non-image area. In addition, the thermal decomposition temperature of the heat sensitive layer was measured according to the method described in the above (6), and the thermal decomposition temperature was 330°C. Further, the solvent resistance was evaluated according to the method described in the above (7), and it was confirmed that no missing of the silicone layer was observed. The evaluation results are shown in Table 1.

### (Comparative Example 4)

A planographic printing plate original was produced and evaluated in the same manner as in Reference Example 1, except that 20 parts by mass of the novolac resin and 60 parts by mass of the polyurethane were used in the heat sensitive layer composition solution-3.

The evaluation of the halftone dot reproducibility was carried out in the same manner as in Reference Example 1, to obtain the following results: the number the 0.5%-halftone dots reproduced: 0; the number the 1.0%-halftone dots reproduced: 0; and the number the 2.0%-halftone dots reproduced: 10. Subsequently, printing was carried out according to the method described in the above (3-3), and the evaluation of the scumming start temperature was carried out according to the method described in the above (4). As a result, it was confirmed that the scumming start temperature was 29°C. Then the scratch resistance was evaluated according to the method described in the above (5), and it was confirmed that there was no defect in the non-image area. In addition, the thermal decomposition temperature of the heat sensitive layer was measured according to the method described in the above (6), and the thermal decomposition temperature was 330°C. Further, the solvent resistance was evaluated according to the method described in the above (7), and it was confirmed that no missing of the silicone layer was observed. The evaluation results are shown in Table 1.

**[Table 1]**

| | Polyurethane | | | | Thermal Decomposition Temperature of Heat Sensitive Layer | Oil Content in Silicone Rubber Layer (wt% ) | Curing Method | Printing Resistance (10,000 sheets) | Dot Reproducibility | | | Scumming Start Temperature (°C) |
|---|---|---|---|---|---|---|---|---|---|---|---|---|
| | Name | Diol (structure) | Content (% by mass) | Ulul (Carbon atom number of alkyl chain in the polyurethane | | | | | 0,5% | 1,0% | 2,0% | |
| example 1* | Polyurethane A | Carbonate | 20 | main chain) 4 | 310 | 0 | Air-blow drying | 5,0 | 0 | 100 | 100 | 32 |
| Example 2' | Polyurethane A | Carbonate | 40 | 4 | 310 | 0 | Air-blow drying | 5,0 | 0 | 80 | 100 | 32 |
| Example 3' | Polyurethane A | Carbonate | 10 | 4 | 310 | 0 | Air-blow drying | 5,0 | 0 | 100 | 100 | 32 |
| Example 4' | Polyurethane A | Carbonate | 50 | 4 | 310 | 0 | Air-blow drying | 5,0 | 0 | 50 | 100 | 32 |
| Example 5' | Polyurethane A | Carbonate | 5 | 4 | 310 | 0 | Air-blow drying | 1,0 | 0 | 80 | 100 | 32 |
| example 6* | Polyurethane A | Carbonate | 5 | 4 | 310 | 0 | Air-blow drying | 1,0 | 0 | 80 | 100 | 32 |
| Example 7* | Polyurethane A | Carbonate | 60 | 4 | 310 | 0 | Air-blow drying | 5,0 | 0 | 0 | 100 | 32 |
| Example 8 | Polyurethane B | Carbonate | 20 | 6 | 290 | 0 | Air-blow drying | 5,0 | 50 | 100 | 100 | 32 |
| Example 9 | Polyurethane B | Carbonate | 20 | 6 | 290 | 10 | Air-blow drying | 10,0 | 100 | 100 | 100 | 35 |
| Example 10 | Polyurethane B | Carbonate | 20 | 6 | 290 | 35 | Air-blow drying | 10,0 | 100 | 100 | 100 | 35 |
| example 11 | Polyurethane B | Carbonate | 20 | 6 | 290 | 50 | Air-blow drying | 7,0 | 100 | 100 | 100 | 35 |
| Example 12 | Polyurethane B | Carbonate | 20 | 6 | 290 | 0 | Active energy ray irradiation | 5,0 | 50 | 100 | 100 | 30 |
| Example 13 | Polyurethane B | Carbonate | 20 | 6 | 290 | 10 | Active energy ray irradiation | 10,0 | 100 | 100 | 100 | 33 |
| Example 14 | Polyurethane B | Carbonate | 20 | 6 | 290 | 35 | Active energy ray irradiation | 10,0 | 100 | 100 | 100 | 33 |
| Example 15 | Polyurethane B | Carbonate | 20 | 6 | 290 | 10 | LED lamp irradiation | 10,0 | 100 | 100 | 100 | 32 |
| Example 16 | Polyurethane B | Carbonate | 20 | 6 | 290 | 35 | LED lamp irradiation | 10,0 | 100 | 100 | 100 | 32 |
| Comparative Example 1 | LQ-T1331 | Ester | 5 | 4 | 330 | 0 | Air-blow drying | 1,0 | 0 | 0 | 60 | 32 |
| Comparative Example 2 | LQ-T1331 | Ester | 60 | 4 | 330 | 0 | Air-blow drying | 5,0 | 0 | 0 | 10 | 32 |
| Comparative Example 3 | LQ-T1331 | Ester | 5 | 4 | 330 | 0 | Active energy ray irradiation | 1,0 | 0 | 0 | 60 | 30 |
| Comparative Example 4 | LQ-T1331 | Ester | 60 | 4 | 330 | 0 | LED lamp irradiation | 5,0 | 0 | 0 | 10 | 29 |
| *: out of the scope of the invention | | | | | | | | | | | | |

### INDUSTRIAL APPLICABILITY

The planographic printing plate original according to the present invention can be used to produce a planographic printing plate. The thus obtained planographic printing plate can be used in the field of printing in general (commercial printing, newspaper printing, and printing on a non-absorbent material such as a film, a resin plate, or a metal). The planographic printing plate original according to the present invention allows for: preventing the occurrence of cissing during the coating of a solution containing a heat sensitive layer composition; exhibiting an excellent printing durability and minute halftone dot reproducibility; as well as preventing the occurrence of scumming.

## Claims

1. A planographic printing plate original comprising: a substrate; and at least a silicone rubber layer and a heat sensitive layer provided on the substrate, wherein the heat sensitive layer contains a polyurethane having a carbonate structure, and contains, in the main chain thereof, an alkyl chain having 6 or more carbon atoms.

2. The planographic printing plate original according to claim 1, wherein the content of the polyurethane with respect to the total solid content of the heat sensitive layer is 10% by mass or more and 50% by mass or less.

3. The planographic printing plate original according to claim 1 or 2, wherein the temperature at which the weight reduction ratio of the heat sensitive layer as measured by thermogravimetry reaches 30% or more, is 270°C or higher and 320°C or lower.

4. The planographic printing plate original according to any one of claims 1 to 3, wherein the silicone rubber layer contains a silicone oil.

5. The planographic printing plate original according to claim 4, wherein the content of the silicone oil in the silicone rubber layer is 10% by mass or more and 35% by mass or less.

6. A method of producing a planographic printing plate, the method comprising the step of irradiating a laser beam to the planographic printing plate original according to any one of claims 1 to 5, followed by applying physical stimulation to the planographic printing plate original.

7. A method of producing a printed matter, the method comprising the steps of:
allowing an ink to adhere to the surface a planographic printing plate obtained by the method of producing a planographic printing plate, according to claim 6; and
transferring the ink to an object to be printed, directly or via a blanket.

8. The method of producing a printed matter, according to claim 7, further comprising the step of irradiating an active energy ray to the object to be printed.

9. The method of producing a printed matter, according to claim 8, wherein the active energy ray has a wavelength of from 300 nm to 450 nm.

## Patentansprüche

1. Flachdruckplattenrohling, der ein Substrat und wenigstens eine Silikonkautschukschicht und eine wärmeempfindliche Schicht auf dem Substrat umfasst, wobei die wärmeempfindliche Schicht ein Polyurethan mit einer Carbonatstruktur enthält und in der Hauptkette desselben eine Alkylkette mit 6 oder mehr Kohlenstoffatomen enthält.

2. Flachdruckplattenrohling nach Anspruch 1, wobei der Anteil des Polyurethans in Bezug auf den gesamten Festkörperanteil der wärmeempfindlichen Schicht 10 Massenprozent oder mehr und 50 Massenprozent oder weniger beträgt.

3. Flachdruckplattenrohling nach Anspruch 1 oder 2, wobei die Temperatur, bei der das Gewichtsreduktionsverhältnis der wärmeempfindlichen Schicht, gemessen durch eine Thermogravimetrie, 30% oder mehr erreicht, 270°C oder höher und 320°C oder niedriger ist.

4. Flachdruckplattenrohling nach einem der Ansprüche 1 bis 3, wobei die Silikonkautschukschicht ein Silikonöl enthält.

5. Flachdruckplattenrohling nach Anspruch 4, wobei der Anteil des Silikonöls in der Silikonkautschukschicht 10 Massenprozent oder mehr und 35 Massenprozent oder weniger beträgt.

6. Verfahren zum Erzeugen einer Flachdruckplatte, wobei das Verfahren einen Schritt zum Strahlen eines Laserstrahls auf den Flachdruckplattenrohling gemäß den Ansprüchen 1 bis 5 und dann das Ausüben einer physikalischen Stimulation auf den Flachdruckplattenrohling umfasst.

7. Verfahren zum Erzeugen eines Druckerzeugnisses, wobei das Verfahren die folgenden Schritte umfasst:
Erlauben des Haftens einer Tinte an der Oberfläche einer durch das Verfahren zum Erzeugen einer Flachdruckplatte von Anspruch 6 erhaltenen Flachdruckplatte, und
Übertragen der Tinte auf ein zu bedruckendes Objekt, direkt oder über ein Tuch.

8. Verfahren zum Erzeugen eines Druckerzeugnisses nach Anspruch 7, das weiterhin einen Schritt zum Strahlen eines aktiven Energiestrahls auf das zu bedruckende Objekt umfasst.

9. Verfahren zum Erzeugen eines Druckerzeugnisses nach Anspruch 8, wobei der aktive Energiestrahl eine Wellenlänge von 300 nm bis 450 nm aufweist.

## Revendications

1. Original de plaque d'impression planographique comprenant : un substrat ; et au moins une couche de caoutchouc de silicone et une couche thermosensible placées sur le substrat, dans lequel la couche thermosensible contient un polyuréthane ayant une structure de carbonate et contient, dans sa chaîne principale, une chaîne alkyle ayant 6 atomes de carbone ou plus.

2. Original de plaque d'impression planographique selon la revendication 1, dans lequel la teneur en le polyuréthane par rapport à la teneur totale en matières solides de la couche thermosensible est de 10 % en masse ou plus et de 50 % en masse ou moins.

3. Original de plaque d'impression planographique selon la revendication 1 ou 2, dans lequel la température à laquelle le taux de réduction de poids de la couche thermosensible, tel que mesuré par thermogravimétrie, atteint 30 % ou plus, est de 270 °C ou plus et de 320 °C ou moins.

4. Original de plaque d'impression planographique selon l'une quelconque des revendications 1 à 3, dans lequel la couche de caoutchouc de silicone contient une huile de silicone.

5. Original de plaque d'impression planographique selon la revendication 4, dans lequel la teneur en huile de silicone de la couche de caoutchouc de silicone est de 10 % en masse ou plus et de 35 % en masse ou moins.

6. Procédé pour produire une plaque d'impression planographique, le procédé comprenant l'étape consistant à irradier avec un faisceau laser l'original de plaque d'impression planographique selon l'une quelconque des revendications 1 à 5, suivie de l'application d'une stimulation physique sur l'original de plaque d'impression planographique.

7. Procédé pour produire un article imprimé, le procédé comprenant les étapes consistant à :
permettre à une encre d'adhérer à la surface d'une plaque d'impression planographique obtenue par le procédé pour produire une plaque d'impression planographique selon la revendication 6 ; et
transférer l'encre sur un objet à imprimer, directement ou par l'intermédiaire d'un blanchet.

8. Procédé pour produire un article imprimé selon la revendication 7, comprenant en outre l'étape consistant à irradier avec un rayon à énergie active l'objet à imprimer.

9. Procédé pour produire un article imprimé selon la revendication 8, dans lequel le rayon à énergie active a une longueur d'onde comprise entre 300 nm et 450 nm.
